(19) **Europäisches Patentamt**
**European Patent Office**
**Office européen des brevets**

(11) **EP 2 871 054 B1**

(12) **EUROPEAN PATENT SPECIFICATION**

(45) Date of publication and mention
of the grant of the patent:
**05.04.2017 Bulletin 2017/14**

(21) Application number: **13812960.6**

(22) Date of filing: **03.07.2013**

(51) Int Cl.:
**B32B 9/00** *(2006.01)*   **B32B 27/00** *(2006.01)*
**B32B 37/00** *(2006.01)*   **H01L 31/042** *(2014.01)*

(86) International application number:
**PCT/JP2013/068222**

(87) International publication number:
**WO 2014/007277 (09.01.2014 Gazette 2014/02)**

(54) **LAMINATE**

LAMINAT

STRATIFIÉ

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **06.07.2012 JP 2012152907**

(43) Date of publication of application:
**13.05.2015 Bulletin 2015/20**

(73) Proprietors:
• **Mitsui Chemicals, Inc.**
**Tokyo 105-7117 (JP)**
• **Mitsui Chemicals Tohcello, Inc.**
**Tokyo 101-8485 (JP)**

(72) Inventors:
• **FUKUMOTO Haruhiko**
**Sodegaura-shi**
**Chiba 299-0265 (JP)**
• **ODAGAWA Kenji**
**Sodegaura-shi**
**Chiba 299-0265 (JP)**
• **USUI Hideo**
**Tokyo 105-7117 (JP)**

• **TAKAHASHI Eiichi**
**Nagoya-shi**
**Aichi 457-8522 (JP)**
• **TAKAKI Toshihiko**
**Tokyo 105-7117 (JP)**
• **TAKANO Masako**
**Koga-shi**
**Ibaraki 306-0213 (JP)**
• **NAKAMURA Osamu**
**Koga-shi**
**Ibaraki 306-0213 (JP)**
• **SHINDO Kiyotaka**
**Koga-shi**
**Ibaraki 306-0213 (JP)**

(74) Representative: **Hoffmann Eitle**
**Patent- und Rechtsanwälte PartmbB**
**Arabellastraße 30**
**81925 München (DE)**

(56) References cited:
**EP-A1- 2 455 220      EP-A1- 2 599 621**
**WO-A1-2011/007543   WO-A1-2012/014653**
**JP-A- 2003 211 576    JP-A- 2003 211 576**
**JP-A- 2007 237 588    JP-A- 2007 237 588**
**JP-A- 2009 095 989    JP-A- 2009 095 989**

EP 2 871 054 B1

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

Printed by Jouve, 75001 PARIS (FR)

**Description**

TECHNICAL FIELD

A laminate that is excellent in terms of oxygen barrier property and water vapor barrier property is provided.

BACKGROUND ART

In recent years, transparent gas barrier materials that block gas such as oxygen or water vapor have been used not only in packaging materials for food and medicinal goods, which have been a principal use, but also in electronic members which are flat panel displays (FPD) such as liquid crystal displays, members (substrates, back sheets and the like) for solar cells, or flexible substrates or sealing films for organic electroluminescent (organic EL) elements. In the above-described uses, there is a demand for an extremely favorable gas barrier property.

Currently, transparent gas barrier materials being employed in some uses are produced by depositing an oxide or nitride of silicon or aluminum or a mixture thereof, which exhibits a gas barrier property, on a plastic base material using a dry process such as a vapor-deposition method, a plasma CVD method, a sputtering method, an ion plating method or a catalyst CVD method. However, in the dry process, there are cases in which fine defects, which are non-accumulated partial portions (pinholes), are formed such that the gas barrier property is impaired.

As a solution for the above-described problem, a laminated film obtained by applying a coating agent mainly containing an aqueous solution or a water/alcohol-mixed solution which contains a water-soluble macromolecule and at least any one of (a) one or more alkoxides or/and hydrolysates thereof and (b) tin chloride over a layer of the oxide or nitride of silicon or aluminum or the mixture thereof which has been produced using the dry process (Patent Document 1) or lamination in which a polymer layer of an unsaturated carboxylic acid metallic salt is coated on an organic layer (Patent Document 2) have been proposed, and there is a report that the barrier property improves by approximately one order of magnitude. However, the barrier performance was still unsatisfactory for electronic members for which a high degree of gas barrier performance is required.

EP 2 455 220 A1 relates to a multilayered material which includes a substrate and a silicon-containing film formed on the substrate, wherein the silicon-containing film has a nitrogen-rich area including silicon atoms and nitrogen atoms, or silicon atoms, nitrogen atoms, and an oxygen atoms and the nitrogen-rich area is formed by irradiating a polysilazane film formed on the substrate with an energy beam in an atmosphere not substantially including oxygen or water vapor and denaturing at least a part of the polysilazane film. A method of producing the multilayered material is also described.

EP 2 599 621 A1 relates to a gas barrier film that is characterized by having a gas barrier layer unit (5) on a side face of at least one surface of a base material (2), wherein the gas barrier layer unit (5) comprises a first barrier layer (3) formed by a chemical vapor deposition method and a second barrier layer (4) formed by applying a silicon compound onto the first barrier layer (3) to form a coating film and modifying the coating film, and wherein the second barrier layer (4) has an unmodified region (4B) on a side facing the base material and a modified region (4A) on a side facing the front layer of the film.

JP 2007-237588 A relates to a gas-barrier film that has a barrier layer which is formed by applying plasma treatment to a polysilazane film on at least one side of the substrate.

JP 2009-095989 A relates to a gas barrier film of an organic-inorganic lamination type having a barrier layer containing an organic layer and an inorganic layer at least on one surface of a plastic film, wherein the barrier layer is composed of the organic layer, a first inorganic layer having a film density of 1.7 or more, and a second inorganic layer whose film density is 0.5-1.5 higher than the first inorganic layer.

JP 2003-211576 A relates to a coated molded article wherein two or more coating layers are provided on the surface of a substrate material, the inner layer in contact with the outermost layer among two or more coating layers comprises a cured layer of a coating composition (A) comprising an active energy beam curable aqueous emulsion containing a polyfunctional urethane (meth)acrylate compound, and the outermost layer comprises a cured layer of a coating composition (B) containing polysilazane. A coated molded article to which post processing such as bending processing or the like is applied is also disclosed.

RELATED DOCUMENT

PATENT DOCUMENT

[Patent Document 1] Japanese Unexamined Patent Publication No. 6-316025

[Patent Document 2] Japanese Unexamined Patent Publication No. 2010-42574

[Patent Document 3] Pamphlet of International Publication No. WO2011/7543

DISCLOSURE OF THE INVENTION

An object of the invention is to provide a laminate having a gas barrier performance sufficient to be used in electronic members.

As a result of comprehensive studies, the present inventors found that, when a silicon-containing layer obtained by irradiating an energy ray such as plasma under predetermined conditions and a polymer layer obtained from an organic acid metallic salt are laminated over a polysilazane film, it is possible to obtain a laminate in which defects such as pinholes are prevented and a sufficient oxygen gas barrier performance, a sufficient water vapor barrier performance and furthermore excellent bending resistance are provided.

That is, the invention can be described as follows.

[1] A laminate comprised of a base material (A), a silicon-containing layer (B) and a polymer layer (C) obtained from an organic acid metallic salt having a polymerizable group,
wherein the silicon-containing layer (B) and the polymer layer (C) are sequentially laminated over at least one surface of the base material (A),
the silicon-containing layer (B) includes a high nitrogen concentration region comprised of silicon atoms and nitrogen atoms, silicon atoms and nitrogen atoms and oxygen atoms, or silicon atoms and nitrogen atoms and oxygen atoms and carbon atoms,
the high nitrogen concentration region is formed by irradiating energy ray onto a polysilazane film formed over the base material (A) under an oxygen concentration equal to or lower than 5% and/or a relative humidity at room temperature (23°C) equal to or lower than 30% so as to denature at least a part of the film,
a composition ratio of the nitrogen atoms, which is measured using X-ray photoelectron spectroscopy and represented by the following formula (1), is in a range of 0.01 to 1 in the high nitrogen concentration region.

$$\text{Formula (1): the composition ratio of the nitrogen atoms/(the}$$

$$\text{composition ratio of the oxygen atoms + the composition ratio of the}$$

$$\text{nitrogen atoms),}$$

and
the organic acid metallic salt is a metallic salt of at least one selected from carboxylic acids, sulfonic acids and mercapto acids.
[2] The laminate according to [1], in which the polymer layer (C) is obtained by forming a film of the organic acid metallic salt having the polymerizable group and polymerizing the organic acid metallic salt film using ultraviolet rays, electron beams or heat over the silicon-containing layer (B) including the high nitrogen concentration region which is formed over the base material (A).
[3] The laminate according to any one of [1] or [2], in which the energy ray irradiation is carried out using plasma radiation.
[4] The laminate according to [3], in which the plasma radiation is carried out under an atmosphere selected from inert gas, rare gas and reducing gas.
[5] The laminate according to [3] or [4], in which the plasma radiation is carried out at an oxygen concentration that is equal to or lower than 5000 ppm and a water vapor concentration that is equal to or lower than 8400 ppm.
[6] The laminate according to any one of [1] to [5], in which the polymerizable group is at least one selected from a vinyl group, an epoxy group, a mercapto group, an ureido group, a sulfide group, an isocyanate group, an amino group, a hydroxyl group, halogen atoms, an oxazoline group, a carbodiimide group and derivatives thereof.
[7] The laminate according to any one of [1] to [6], in which a metal that forms the organic acid metallic salt is at least one metal selected from lithium, sodium, magnesium, calcium, zinc and barium.
[8] The laminate according to any one of [1] to [7], in which the polymer layer (C) further contains a silane coupling agent.
[9] An electronic member made up of a member including elements selected from an organic electroluminescence element, an electronic paper display element and a liquid crystal display element; and the laminate according to any one of [1] to [8] provided with the polymer layer (C) facing the member.

[10] A method for manufacturing a laminate including:

a step of forming a polysilazane film over at least one surface of a base material (A);
a step of irradiating energy ray onto the polysilazane film at an oxygen concentration that is equal to or lower than 5% and/or a relative humidity at room temperature (23°C) that is equal to or lower than 30% so as to denature at least a part of the film and to form a silicon-containing layer (B) including a high nitrogen concentration region comprised of silicon atoms and nitrogen atoms, or silicon atoms, nitrogen atoms and oxygen atoms; and
a step of forming a polymer layer (C) obtained from an organic acid metallic salt having a polymerizable group on the silicon-containing layer (B)
in which a composition ratio of the nitrogen atoms, which is measured using X-ray photoelectron spectroscopy and represented by the following formula (1), is in a range of 0.01 to 1 in the high nitrogen concentration region

Formula (1): the composition ratio of the nitrogen atoms/(the composition ratio of the oxygen atoms + the composition ratio of the nitrogen atoms),

and
the organic acid metallic salt is a metallic salt of at least one selected from carboxylic acids, sulfonic acids and mercapto acids.

[11] The method for manufacturing a laminate according to [10], in which the energy ray irradiation is carried out using plasma radiation.
[12] The method for manufacturing a laminate according to [11], in which the plasma radiation is carried out under an atmosphere gas selected from inert gas, rare gas and reducing gas.

Since the silicon-containing layer (B) denatured by energy ray irradiation and the polymer layer (C) obtained from an organic acid metallic salt having a polymerizable group are sequentially laminated over the base material (A), the laminate of the invention has excellent bending resistance, a pinhole-free dense silicon-containing layer can be obtained, and it is possible to provide a favorable oxygen gas barrier property and a favorable water vapor barrier property for electronic members, compared with laminates of an inorganic layer and an organic layer of the related art.

BRIEF DESCRIPTION OF THE DRAWINGS

FIG. 1 is a schematic cross-sectional view of an electronic member in which a laminate of the invention is used.
FIG. 2 is a view showing the XPS measurement results of a silicon-containing layer (B) obtained by carrying out a low-pressure plasma treatment in Example 1.

DESCRIPTION OF EMBODIMENTS

A laminate of the invention is comprised of a base material (A), a silicon-containing layer (B) and a polymer layer (C) obtained from an organic acid metallic salt having a polymerizable group which are sequentially laminated over at least one surface of the base material (A), and the silicon-containing layer (B) includes a high nitrogen concentration region comprised of silicon atoms and nitrogen atoms, silicon atoms and nitrogen atoms and oxygen atoms, or silicon atoms, nitrogen atoms, oxygen atoms and carbon atoms.
Hereinafter, the base material (A), the silicon-containing layer (B), the polymer layer (C) and other arbitrarily used layers will be sequentially described in detail.

[Base material (A)]

The base material (A) in the invention is not particularly limited as long as the base material is a resin, and examples thereof include polyolefins such as polyethylene, polypropylene, poly-4-methyl-1-pentene and polybutene; cyclic olefin polymers; polyimides; polyesters such as polyethylene terephthalate, polybutylene terephthalate and polyethylene naphthalate; polyamides such as nylon 6, nylon 66 and polymeta-xylyene adipamide, polyphenylene sulfide, and mixtures thereof. Among these, polypropylene, polyethylene terephthalate, polyamide and the like are preferable since it is possible to obtain films that are favorable in terms of stretching property, transparency and stiffness.

Meanwhile, the base material (A) in the invention may appropriately contain as necessary an ultraviolet absorbent, an antioxidant, an antistatic agent, a surfactant, a dye, a fluorescent brightener or the like; furthermore, inorganic particles such as silica, calcium carbonate and titanium oxide and organic particles containing acryl, styrene and the like as constituent components as long as the effects of the invention are not impaired.

[Silicon-containing layer (B)]

The silicon-containing layer (B) includes a high nitrogen concentration region obtained by irradiating energy ray onto a polysilazane film so as to denature at least a part of the polysilazane film. The polysilazane film other than the region denatured by energy ray irradiation can change into silicon oxide ($SiO_2$) through a reaction with water vapor that passes from a base material (A) side after energy ray irradiation.

The silicon-containing layer (B) is comprised of the high nitrogen concentration region and a silicon oxide region. Due to the configuration of the high nitrogen concentration region/ silicon oxide/ the resin base material, the silicon-containing layer (B) has an excellent gas barrier property such as an oxygen barrier property and a water vapor barrier property compared with a single layer film of $SiO_2$, $Si_3N_4$ or the like.

The thickness of the silicon-containing layer (B) is preferably in a range of 0.01 $\mu$m to 4.0 $\mu$m, more preferably in a range of 0.02 $\mu$m to 2.0 $\mu$m, and more preferably in a range of 0.05 $\mu$m to 1.0 $\mu$m.

The silicon-containing layer (B) in the invention includes a high nitrogen concentration region obtained by irradiating a specific energy ray under an atmosphere of low oxygen and/or low water vapor, preferably, under an atmosphere of low oxygen and low water vapor so as to denature the polysilazane film. The high nitrogen concentration region can be formed at a low temperature without heating the polysilazane film when specific conditions are satisfied, and the high nitrogen concentration region has an important role in the favorable water vapor barrier property of the silicon-containing layer (B). This condition is preferable for the base material (A) having low thermal resistance.

In the present specification, "the atmosphere of low oxygen and/or low water vapor" refers to an atmosphere in which there is no oxygen and/or water vapor or an atmosphere in which the concentration of oxygen is equal to or lower than 5%, is preferably equal to or lower than 0.5% (5000 ppm), is more preferably equal to or lower than 0.05% (500 ppm), is more preferably equal to or lower than 0.005% (50 ppm), and is more preferably equal to or lower than 0.002% (20 ppm) and the relative humidity at room temperature (23°C) is equal to or lower than 30%, preferably equal to or lower than 10%, more preferably equal to or lower than 0.5%, more preferably equal to or lower than 0.2%, and more preferably equal to or lower than 0.1%. In addition, when "the atmosphere of low water vapor" is represented by the concentration of water vapor (the partial pressure of water vapor/ atmospheric pressure at room temperature (23°C)), the concentration of the water vapor is equal to or lower than 8400 ppm, preferably equal to or lower than 2800 ppm, more preferably equal to or lower than 140 ppm, still more preferably equal to or lower than 56 ppm, and still more preferably equal to or lower than 28 ppm.

The energy radiation can be carried out in a pressure range of a low pressure that is equal to or larger than 0.1 Pa to atmospheric pressure.

Meanwhile, the present embodiment has been described using an example in which the thickness of the silicon-containing layer (B) is in a range of 0.1 $\mu$m to 0.2 $\mu$m and the high nitrogen concentration region is formed throughout the entire vicinity of the top surface of the silicon-containing layer (B), but the high nitrogen concentration region may be formed on a part of the vicinity of the top surface of the silicon-containing layer (B).

In addition, the high nitrogen concentration region may be formed throughout the entire layer of the silicon-containing layer (B). In this case, the silicon-containing layer (B) has the same composition as the high nitrogen concentration region.

The high nitrogen concentration region is comprised of at least silicon atoms and nitrogen atoms, at least silicon atoms and nitrogen atoms and oxygen atoms, or at least silicon atoms, nitrogen atoms, oxygen atoms and carbon atoms. In the embodiment, the high nitrogen concentration region is comprised of $Si_3N_4$, $SiO_xN_y$ and the like.

In addition, the composition ratio of the nitrogen atoms in the high nitrogen concentration region, which is measured using X-ray photoelectron spectroscopy, is in a range of 0.01 to 1, and preferably in a range of 0.1 to 1 in the following formula (1).

```
Formula (1): the composition ratio of the nitrogen atoms/(the

composition ratio of the oxygen atoms + the composition ratio of the

nitrogen atoms)
```

The silicon-containing layer (B) which includes the high nitrogen concentration region having the above-described composition and is formed by the energy radiation of the polysilazane film is particularly excellent in terms of gas barrier properties such as oxygen barrier property and water vapor barrier property, mechanical characteristics such as abrasion resistance. That is, when including the high nitrogen concentration region having the above-described composition, the laminate can improve barrier properties and mechanical properties in a well-balanced manner.

In addition, the composition ratio of the nitrogen atoms to all atoms in the silicon-containing layer (B), which is measured using X-ray photoelectron spectroscopy, is preferably higher on the polymer layer (C) side of the silicon-containing layer (B) than on the other side surface from the viewpoint of the improvement of gas barrier properties.

Meanwhile, the atomic composition gradually changes between the silicon-containing layer (B) and the high nitrogen concentration region. Since the composition continuously changes as described above, not only do barrier properties improve, but mechanical characteristics also improve.

The thickness of the high nitrogen concentration region is in a range of 0.001 $\mu$m to 0.2 $\mu$m, preferably in a range of 0.005 $\mu$m to 0.1 $\mu$m, and more preferably in a range of 0.01 $\mu$m to 0.1 $\mu$m since the laminate can develop gas barrier properties and mechanical characteristics.

The high nitrogen concentration region may have a thickness in the above-described range on a part of the top surface of the silicon-containing layer (B), but the high nitrogen concentration region preferably has a thickness in the above-described range on the entire top surface of the silicon-containing layer (B) from the viewpoint of the above-described effect.

When producing the silicon-containing layer (B) on the base material (A), a coat containing polysilazane is formed on the base material (A) . The coat is preferably formed using a wet method, and, specifically, a polysilazane-containing solution is applied.

As the polysilazane, it is possible to use at least one selected from perhydropolysilazane, organopolysilazanes and derivatives thereof. Examples of the derivatives include perhydropolysilazane and organopolysilazanes in which some or all of hydrogen atoms are substituted by an organic group such as an alkyl group, an oxygen atom or the like.

In the embodiment, it is preferably used perhydropolysilazane represented by $H_3Si(NHSiH_2)_nNHSiH_3$, but organopolysilazanes in which some or all of hydrogen atoms are substituted by an organic group such as an alkyl group may be used. In addition, the perhydropolysilazane may be used in a single composition or may be used in a mixture of two or more components as well.

The polysilazane-containing solution may contain a metallic carboxylic acid salt as a catalyst that turns polysilazane into ceramic. The metallic carboxylic acid salt is a compound represented by the following general formula.

$$(RCOO)nM$$

In the formula, R represents an aliphatic group or an alicyclic group having 1 to 22 carbon atoms, M represents at least a metal selected from the following metal group, and n represents the atomic valence of a metal M.

M is selected from a group consisting of nickel, titanium, platinum, rhodium, cobalt, iron, ruthenium, osmium, palladium, iridium and aluminum, and is particularly preferably palladium (Pd). The metallic carboxylic acid salt may be an anhydride or a hydrate. In addition, the weight ratio of the metallic carboxylic acid salt to polysilazane is preferably in a range of 0.001 to 1.0, and more preferably in a range of 0.01 to 0.5.

In addition, an acetyl acetonate complex is an example of another catalyst. The metal-containing acetyl acetonate complex is a complex in which negative ions acac$^-$ generated by acid dissociation from acetylacetone (2,4-pentanedione) are coordinated around a metal atom, and is represented by the following general formula.

$$(CH_3COCHCOCH_3)_nM$$

In the formula, M represents an n-valent metal.

M is selected from a group consisting of nickel, titanium, platinum, rhodium, cobalt, iron, ruthenium, osmium, palladium, iridium and aluminum, and is particularly preferably palladium (Pd). The weight ratio of the metallic carboxylic acid salt to polysilazane is preferably in a range of 0.001 to 1.0, and more preferably in a range of 0.01 to 0.5.

Furthermore, examples of another catalyst include amine compounds, pyridines, DBU, DBN and the like, and/or acid compounds such as organic acids or inorganic acids.

Typical examples of the amine compounds include compounds represented by the following general formula.

$R^4R^5R^6N$ In the formula, $R^4$ to $R^6$ respectively represent a hydrogen atom, an alkyl group, an alkenyl group, a cycloalkyl group, an aryl group, an alkylsilyl group, an alkylamino group or an alkoxy group. Specific examples of the amino compounds include methyl amine, dimethyl amine, trimethyl amine, ethyl amine, diethyl amine, triethyl amine, propyl amine, dipropyl amine, tripropyl amine, butyl amine, dibutyl amine, tributyl amine, pentyl amine, dipentyl amine, tripentyl amine, hexyl amine, dihexyl amine, trihexyl amine, heptyl amine, diheptyl amine, triheptyl amine, octyl amine, dioctyl amine, trioctyl amine, phenyl amine, diphenyl amine, triphenyl amine and the like. Meanwhile, a hydrocarbon chain included in the amine compounds may be a straight chain or a branched chain. The amine compounds are particularly preferably triethyl amine, tripentyl amine, tributyl amine, trihexyl amine, triheptyl amine and trioctyl amine.

Specific examples of the pyridines include pyridine, α-picoline, β-picoline, γ-picoline, piperidine, lutidine, pyrimidine, pyridazine, DBU (1,8-diazabicyclo[5.4.0]-7-undecene), DBN (1,5-diazabicyclo[4.3.0]-5-nonene) and the like.

Specific examples of the acid compounds include organic acids such as acetic acid, propionic acid, butyric acid, valeric acid, maleic acid and stearic acid; inorganic acids such as hydrochloric acid, nitric acid, sulfuric acid and hydrogen peroxide; and the like. The acid compounds are particularly preferably propionic acid, hydrochloric acid and hydrogen peroxide.

The addition amount of the amine compounds, pyridines, DBU, DBN and the like, and/or acid compounds such as organic acids or inorganic acids to polysilazane is equal to or larger than 0.1 ppm, and preferably in a range of 10 ppm to 10% with respect to the weight of polysilazane.

A transition metal compound may be added to affect a Si-H bond in polysilazane and activate the state of the same bond, thereby facilitating a reaction caused by the energy ray irradiation of polysilazane. In conclusion, when a transition metal compound is added, a strong effect can be expected with a short period of radiation.

A transition metal species in the above-described transition metal compound is a compound containing platinum (Pt), ruthenium (Ru), rhodium (Rh), iridium (Ir), iron (Fe), osmium (Os), cobalt (Co), palladium (Pd), nickel (Ni), titanium (Ti), vanadium (V), chromium (Cr), manganese (Mn), molybdenum (Mo), tungsten (W), niobium (Nb), tantalum (Ta), zirconium (Zr), hafnium (Hf), scandium (Sc), yttrium (Y), lanthanum (La) or rhenium (Re) or a mixture thereof.

As the transition metal compound, a transition metal halide, a complex, a transition metal salt or a transition metal oxide is used.

The halide refers to a compound formed by bonding the transition metal and chlorine (Cl), bromine (Br), iodine (I) or fluorine (F).

All halides of the above-described transition metal can be effectively used, but chloroplatinic acid $(H_2PtCl_6 \cdot nH_2O)$, $PtCl_2$, $PtCl_4$, $PtCl_2(NH_3)_2$, $Na_2(PtCl_4) \cdot nH_2O$, $[PtCl(cyclohexene)_2](\mu\text{-Cl})_2$, $RhCl_3$, Tris(dibutylsulfide)$RhCl_3$, $(NH_4)_3[RhCl_6]$, $RhI_3$, $(NH_3)_6RhCl_3$, $RuCl_3$, $[Ru(p\text{-cymeme})Cl_2]_2$, $[Ru\ (benzene)\ Cl_2]_2$, $(NH_4)_2RuCl_6$, $(NH_3)_4[RuCl_4(H_2O)]_2(\mu\text{-N})$, Ni(triphenylphosphine)$_3Br_2$, $Mn(CO)_5Br$, $IrCl_3$, $(NH_4)_2IrCl_6$, $FeCl_3$, $PdCl_2 \cdot 2H_2O$, $NiCl_2$, $TiCl_4$, $OsCl_3$, $(NH_4)_2OsCl_6$, W (cyclopentadiene) $_2Cl_2$ and mixtures thereof are more preferably used.

Examples of the complex include olefin complexes, cyclic olefin complexes, vinyl siloxane complexes, phosphine complexes, phosphite complexes, carbon monoxide complexes (CO), amine complexes and nitrile complexes. The above-described complexes were used as a catalyst for a reaction mainly with an organic substance including a SiH group, a vinyl group and the like in the past, and are known to facilitate the dissociation of the Si-H bond. In the techniques of the invention, the addition of the complex can facilitate a reaction caused by the energy ray irradiation of polysilazane. Any transition metal complexes similar to the above-described complexes can be used, but Pt-1,3-divinyl-1,1,3,3-tetramethyldisiloxane (Pt[CH$_2$=CH (methyl)Si]$_2$O), Pt(CO)(CH$_2$=CH (methyl) SiO)$_4$, Pt[CH$_2$=CH(methyl)SiO]$_4$, Pt(triphenylphosphine)$_2Cl_2$, Ph(cyclooctadiene)Cl$_2$, [Rh(cyclooctadiene)]$_2(\mu\text{-Cl})_2$, Rh(acetylacetonato)(CO)$_2$, Rh(triphenylphosphine)$_3$Cl, Rh(triphenylphosphine)$_2Cl_2$, [(Bicyclo[2.2.1]hepta-2,5-diene)RhCl]$_2$, Rh(acetylacetonato)(CO)(triphenylphosphine), Rh(acetylacetonato)(cyclooctadiene), Rh(CO)(triphenylphosphine)$_2$Cl, RhH(CO)(triphenylphosphine)$_3$, [RhCl(pentamethylcyclopentadienyl)]$_2(\mu\text{-Cl})_2$, Rh$_6$(CO)$_{16}$, Ru(triphenylphosphine)$_3Cl_2$, [RuCl$_2$(CO)$_3$]$_2$, [Benzylidenebis(tricyclophosophine)]RuCl$_2$, Ru$_3$(CO)$_{12}$, [(2-Methylallyl)PdCl]$_2$, NaHRu$_3$(CO)$_{11}$, (Triphenylphosphine)$_3$RuH$_2$(CO), Ru(cyclooctadiene)Cl$_2$]n, (Acenaphthylene)Ru$_3$(CO)$_7$, [RuCl(p-cymeme)]$_2(\mu\text{-Cl})_2$, (Pentamethylcyclopentadiene)Ru(cyclooctadiene)Cl, Cr(CO)$_6$, Zr(cyclopentadiene)Cl$_3$, Zr(cyclopentadiene)$_2Cl_2$, Zr(cyclopentadiene)$_2$HCl, (Pentamethylcyclopentadiene)$_2$ZrCl$_2$, Mo(CO)$_6$, Mo(cyclopentadiene)$_2$Cl$_2$Mo(cyclopentadiene)Cl$_4$, [(Pentamethylcyclopentadiene)Mo(CO)$_3$]$_2$, Nb(cyclopentadiene)Cl$_4$, Nb(cyclopentadiene)$_2Cl_2$, Nb(triphenylphosphine)$_4$, Pd(triphenylphosphine)$_2Cl_2$, Pd(triphenylphosphine)$_4$, (Pentamethylcyclopentadiene)$_2$HfCl$_2$, Hf(cyclopentadiene)Cl$_3$, (Pentamethylcyclopentadiene)HfCl$_3$, Ir(CO)(triphenylphosphine)$_2$Cl, Ir$_4$(CO)$_{12}$, IrH(triphenylphosphine)$_3$Cl, [IrCl(pentamethylcyclopentadiene)]$_2(\mu\text{-Cl}_2)$, [Ir(cyclooctadiene)]$_2(\mu\text{-Cl})_2$, (Pentamethylcyclopentadiene)TaCl$_4$, (Pentamethylcyclopentadiene)$_2$Co, [(Pentamethylcyclopentadiene)Co(CO)$_2$]$_2$, La(cyclooctadiene)$_3$, Ni(triphenylphosphine)$_3Cl_2$, Ni(triphenylphosphine)$_3$(CO)$_2$, Ni(cyclopentadiene)$_2$, Mn$_2$(CO)$_{10}$, Mn(cyclopentadiene)(CO)$_3$, Mn(cyclopentadiene)$_2$, Mn(pentamethylcyclopentadiene)$_2$, Ti (benzene) $_2Cl_2$, Fe(CO)$_5$, Fe$_2$(CO)$_9$, [Fe (cyclopentadiene) (CO)$_2$]$_2$, Os$_3$(CO)$_{12}$, Re$_2$(CO)$_{10}$, Re(CO)$_5$Cl, Re(CO)$_5$Br, Re(cyclopentadiene)(CO)$_3$, W(CO)$_6$, W(cyclopentadiene)(CO)$_3$, Sc(cyclopentadiene)$_3$, V(CO)$_6$, V(cyclopentadiene)(CO)$_4$, Y[N,N-bis(trimethylsilyl)amide]$_3$, Y(cyclopentadiene)$_3$, mixtures thereof and the like are more preferable.

Examples of the transition metal salt include tetrafluoroboric acid ($BF_4$) salts, hexafluorophosphoric acid ($PF_6$) salts, hexafluoroantimonate, tetrakis(perfluorophenyl) borate, perchlorate and trifluoromethansulfonic acid ($CF_3SO_3$) salts. Any transition metal salts similar to the above-described transition metal salts can be used, but Rh(cyclooctadiene)$_2$BF$_4$, Pentamethylcyclopentadienyltris(acetonitrile)RuPF$_6$, (Pentamethylcyclopentadiene)$_2$CoPF$_6$, La(CF$_3$SO$_3$)$_3$, Sc(CF$_3$SO$_3$)$_3$, mixtures thereof and the like are more preferable.

The transition metal oxide refers to a compound formed by bonding one or more oxygen atoms to the above-described transition metal.

The weight ratio of the transition metal compound to polysilazane is preferably in a range of 0.0001 to 1.0, more preferably in a range of 0.001 to 0.5, and still more preferably in a range of 0.01 to 0.2.

The polysilazane-containing solution can contain fine particles of a metal. The metal is preferably Ag. The particle diameter of the fine metal particles is preferably equal to or lower than 0.5 $\mu$m, more preferably equal to or lower than 0.1 $\mu$m, and still more preferably equal to or lower than 0.05 $\mu$m. Particularly, a polysilazane-containing solution obtained by dispersing independently-dispersed ultrafine particles having a particle diameter in a range of 0.005 $\mu$m to 0.01 $\mu$m in an alcohol having a high boiling point is preferable. The addition amount of the fine metal particles is in a range of 0.01 parts by weight to 10 parts by weight, and preferably in a range of 0.05 parts by weight to 5 parts by weight with respect to 100 parts by weight of polysilazane.

In the polysilazane-containing solution, polysilazane, a catalyst and fine metal particles and the like, which are used as necessary, are dissolved or dispersed in a solvent.

Examples of the solvent include aromatic compounds such as benzene, toluene, xylene, ethyl benzene, diethyl benzene, trimethyl benzene and triethyl benzene; saturated hydrocarbon compounds such as n-pentane, i-pentane, n-hexane, i-hexane, n-heptane, i-heptane, n-octane, i-octane, n-nonane, i-nonane, n-decane and i-decane; ethyl cyclohexane, methyl cyclohexane, cyclohexane, cyclohexene, p-menthane, decahydronaphthalene, dipentene; ethers such as dipropyl ether, dibutyl ether, methyl tert-butyl ether (MTBE) and tetrahydroxy furan; ketones such as methyl isobutyl ketone (MIBK), methylene chloride, carbon tetrachloride and the like. The above-described solvent may be solely used or used in a mixture form.

Since a well-known application method can be applied, the method for applying the polysilazane-containing solution to the base material (A) is not particularly limited, and examples thereof include a bar coating method, a roll coating method, a gravure coating method, a spray coating method, an air knife coating method, a spin coating method, a dip coating method and the like.

In addition, since the silicon-containing layer is formed through wet application in the embodiment, unlike the method described in Patent Document 2, it is not necessary to provide an undercoat layer so that the number of layers can be decreased and there is an advantage in decreasing the cost or simplifying the process.

Energy ray irradiation is carried out on the polysilazane film in a low oxygen and/or low water vapor atmosphere so as to denature at least a part of the polysilazane film and form the silicon-containing layer (B) including the high nitrogen concentration region. A plasma treatment can be used as the energy ray irradiation, and it is also possible to use a combination of plasma treatments.

When the plasma treatment is carried out, since it is possible to uniformly form the high nitrogen concentration region compared with other energy ray irradiations, the barrier properties, particularly, the water vapor barrier properties of the silicon-containing layer (B) are excellent, which is preferable.

(Plasma treatment)

The plasma treatment used in the invention will be hereinafter described. In the plasma treatment, plasma at a low pressure plasma, or plasma at near atmospheric pressure is used. More preferably, low-pressure plasma is a preferable treatment method.

(Plasma gas type)

From the viewpoint of forming the high nitrogen concentration region in the silicon-containing layer, examples of gas used in the plasma treatment include an inert gas such as nitrogen gas, rare gases such as argon gas, helium gas, neon gas, krypton gas and xenon gas, reducing gases such as hydrogen gas and ammonia gas. More preferably examples of the gas include argon gas, helium gas, nitrogen gas, hydrogen gas or gas mixtures thereof.

(Low-pressure plasma treatment)

As low-pressure plasma, it is possible to generate an arbitrary plasma by disposing a well-known electrode or waveguide in a closed vacuum system and applying the power of a direct current, an alternating current, radio waves, micro waves or the like through the electrode or the waveguide. The power (W) being applied during the plasma treatment is preferably in a range of 0.0001 $W/cm^2$ to 100 $W/cm^2$, and more preferably in a range of 0.001 $W/cm^2$ to 50 $W/cm^2$ per unit area ($cm^2$) of the electrode.

The plasma treatment can be carried out at a low pressure that is equivalent to a low oxygen and/or low water vapor atmosphere. The low pressure refers to a pressure that is equal to or lower than 100 Pa, and preferably a pressure that is equal to or lower than 10 Pa. A low pressure state in an apparatus can be obtained by reducing the pressure in the apparatus from atmospheric pressure (101325 Pa) to a pressure that is equal to or lower than 100 Pa and preferably equal to or lower than 10 Pa using a vacuum pump such as a hydraulic rotary pump or a turbo molecular pump, and then introducing the above-described plasma gas up to a pressure that is equal to or lower than 100 Pa.

The oxygen concentration and the water vapor concentration at a low pressure are generally evaluated using an oxygen partial pressure and a water vapor partial pressure.

In a case in which the plasma treatment is carried out in an atmosphere that does not satisfy the above-described conditions, since the high nitrogen concentration region of the embodiment is not formed, and a silanol group (Si-OH) is generated, there are cases in which a sufficient water vapor barrier property cannot be obtained.

(The pressure range of the low-pressure plasma)

In the low-pressure plasma treatment, the above-described kind of plasma gas is introduced, and the treatment is carried out at a gas partial pressure of a low pressure in a range of 500 Pa to 0.1 Pa. More preferably, when the treatment is carried out at a pressure in a range of 100 Pa to 0.1 Pa, the plasma generation coefficient is favorable.

(Method for generating low-pressure plasma)

As a method for generating plasma used in the invention, a conventionally known method can be used. A method that can treat the polysilazane film formed on the base material (A) having a large width is preferable, and examples thereof include methods (A) to (E) described below.

(A) Capacitively coupled plasma (CCP)

Capacitively coupled plasma is a method that generates plasma between an electrode on a high-frequency power-applied side and an electrode on a grounding side, and parallel plate electrodes are a typical electrode structure. The electrode on the high-frequency power-applied side does not necessarily have a plate shape and may have an uneven shape.

(B) Inductively coupled plasma (ICP)

Inductively coupled plasma is a method in which a high-frequency current is made to flow through an antenna coil so as to generate magnetic field and plasma is generated by using an induction electric field based on the magnetic field, and, in general, a high electron density (plasma density) can be obtained compared with the capacitively coupled plasma. Any one of an outside antenna type in which an antenna coil is placed outside a chamber through a dielectric layer and an inside antenna type in which an antenna coil is installed in a chamber may be employed. In addition, since the polysilazane film formed on the base material having a large width is treated, efforts may be made to dispose the antenna coil in an array shape.

In the above-described apparatus configuration, when the injected power is increased, discharge caused by electrostatic coupling with a coil antenna (called an E mode) is changed to discharge caused by inductive coupling (called an H mode). Sometimes, there are cases in which a phenomenon in which the plasma density abruptly increases as the mode change phenomenon is observed. When the polysilazane film is treated, it is necessary to inject a sufficient power so as to form H-mode plasma.

(C) Surface wave plasma
(D) Electron cyclotron resonance (ECR) plasma
(E) Helicon wave plasma

(The plasma treatment at near atmospheric pressure)

Examples of the plasma treatment at near atmospheric pressure include a method in which gas is made to pass between two electrodes, the gas is made into plasma, and then is radiated on the base material (A), a method in which a polysilazane film-attached base material to be irradiated is disposed between two electrodes, and gas is made to pass through the base material, thereby producing plasma, and the like.

In a case in which an atmospheric pressure plasma treatment is carried out, it is necessary to carry out the treatment in the low oxygen and/or low water vapor atmosphere. The plasma gas flow rate is preferably higher in order to form the low oxygen and/or low water vapor concentration atmosphere, and the plasma gas flow rate is preferably in a range of 0.01 L/min to 1000 L/min, and more preferably in a range of 0.1 L/min to 500 L/min.

(The plasma pressure range at near atmospheric pressure)

In the plasma treatment at near atmospheric pressure, the power (W) being applied is preferably in a range of 0.0001 W/cm$^2$ to 100 W/cm$^2$, and more preferably in a range of 0.001 W/cm$^2$ to 50 W/cm$^2$ per unit area (cm$^2$) of an electrode. In the plasma treatment at near atmospheric pressure, the movement rate of the polysilazane film-attached base material is preferably in a range of 0.001 m/min to 1000 m/min, and more preferably in a range of 0.001 m/min to 500 m/min.

When the above-described steps are carried out, the silicon-containing layer (B) of the invention can be manufactured. Meanwhile, the following treatment may be further carried out on the silicon-containing layer (B).

An undercoat layer may be provided between the base material (A) and the silicon-containing layer (B) to suppress the precipitation of oligomers and additives in the base material (A). The undercoat layer is optimally formed by coating a layer with a polymerizable monomer or oligomer having at least one vinyl group in the molecule and causing a crosslinking reaction using heating, ultraviolet rays, electron beams or the like. In particular, ultraviolet rays, electron beams or the like are preferably used since the reactivity is favorable. Examples of the polymerizable monomer include epoxy (meth)acrylate-based oligomers, urethane (meth)acrylate-based oligomers, polyester (meth)acrylate-based oligomers, polyether (meth)acrylate-based oligomers, vinyl-based oligomers, unsaturated polyester-based oligomers, and monomers such as acrylates, methacrylates, vinyl esters and the like having a variety of monofunctional groups and polyfunctional groups. Among these, an epoxy (meth)acrylate-based undercoat layer or a urethane (meth)acrylate-based undercoat layer is preferably provided, and, in particular, a urethane (meth)acrylate-based undercoat layer is desirably provided.

Examples of an epoxy (meth)acrylate-based compound include compounds obtained by reacting an epoxy compound such as a bisphenol A-type epoxy compound, a bisphenol F-type epoxy compound, a bisphenol S-type epoxy compound, a phenol novolac-type epoxy compound, a cresol novolac-type epoxy compound or a fatty acid epoxy compound and acrylic acid or methacrylic acid, and, furthermore, acid-denatured epoxy (meth)acrylates obtained by reacting the above-described compound and carboxylic acid or an anhydride thereof. The epoxy (meth)acrylate-based compound is applied to a surface of the base material (A) together with a photopolymerization initiator and, if necessary, a diluent comprised of other photopolymerization or thermally reactive monomers, and then is irradiated with ultraviolet rays or the like, thereby forming an undercoat layer using a crosslinking reaction.

The urethane (meth)acrylate-based compound is comprised of acrylated oligomers that are comprised of a polyol compound and a diisocyanate compound.

The polyurethane-based oligomer can be obtained from a condensation product of a polyisocyanate and a polyol. Specific examples of the polyisocyanate include methylene bis(p-phenylene diisocyanate), adducts of hexamethylene diisocyanate hexane triol, hexamethylene diisocyanate, tolyene isocyanate, adducts of trilene diisocyanate trimethylolpropane, 1,5-naphthylene diisocyanate, thiopropyl diisocyanate, ethylbenzene-2,4-diisocyanate, 2,4-trilene diisocyanate dimers, hydrogenated xylene diisocyante, tris(4-phenyl isocyanate)thiophosphate. In addition, specific examples of the polyol include polyether-based polyols such as polyoxy tetramethylene glycol; polyester-based polyols such as polyadipate polyol and polycarbonate polyol; copolymers of an acrylic acid ester and hydroxyethyl methacrylate; and the like. Examples of the monomer that configures the acrylate include methyl (meth)acrylate, ethyl (meth)acrylate, butyl (meth)acrylate, 2ethyl hexyl (meth)acrylate, methoxyethyl (meth)acrylate, butoxyethyl (meth)acrylate, phenyl (meth)acrylate and the like.

The epoxy (meth)acrylate-based compound and the urethane (meth)acrylate-based compound are jointly used if necessary. In addition, the epoxy (meth)acrylate-based compound and the urethane (meth) acrylate-based compound can be polymerized using a variety of well-known methods, specifically, using the radiation of ionizing radioactive rays, heating or the like.

In a case in which the epoxy (meth) acrylate-based compound and the urethane (meth) acrylate-based compound are used after being cured using ultraviolet rays, a photopolymerization initiator such as acetophenone, benzophenone, Mifi Raven benzoyl benzoate, an α-amyloxime ester or a thioxanthone and a photosensitizer such as n-butylamine, triethylamine or tri-n-butylphosphine are preferably used in a mixture form. In the invention, the epoxy (meth) acrylate-based compound and the urethane (meth) acrylate-based compound are sometimes jointly used.

In addition, the epoxy (meth)acrylate-based compound or the urethane (meth)acrylate-based compound is diluted using a (meth) acrylate-based monomer. Examples of the (meth) acrylate-based monomer include methyl (meth)acrylate, ethyl (meth)acrylate, butyl (meth)acrylate, 2-ethylhexyl (meth)acrylate, methoxyethyl (meth)acrylate, butoxyethyl (meth)acrylate and phenyl (meth)acrylate, and examples of a polyfunctional monomer include trimethylolpropane tri(meth)acrylate, hexanediol (meth)acrylate, tripropylene glycol di(meth)acrylate, diethylene glycol di(meth)acrylate, pentaerythritol tri(meth)acrylate, dipentaerythritol hexa(meth)acrylate, 1,6-hexanediol di(meth)acrylate, neopentyl glycol di(meth)acrylate and the like.

Among the above-described compounds, in a case in which the urethane (meth) acrylate-based compound is used as the undercoat layer, the urethane (meth)acrylate-based compound contributes to the improvement in the oxygen gas barrier property of gas barrier films being obtained.

The undercoat layer is generally in a range of 0.05 $g/m^2$ to 5.0 $g/m^2$, and preferably in a range of 0.1 $g/m^2$ to 3.0 $g/m^2$.

In addition, it is desirable to carry out a pretreatment such as a corona treatment, a glow discharge treatment, an atmospheric pressure plasma treatment or a vacuum plasma discharge treatment on the surface of the silicon-containing layer (B) before forming the polymer layer (C) of a metallic salt on the layer (B). Among the above-described treatments, the corona treatment is preferable. The conditions of the corona treatment are not particularly limited, and, for example, discharge frequencies in a range of 5 kHz to 40 kHz and approximately in a range of 10 kHz to 30 kHz can be used, and alternating current sine waves can be used as a wave shape. The clearance of the gap between the electrode and the dielectric roll can be set in a range of 0.1 mm to 10 mm and approximately in a range of 1.0 millimeter to 2.0 mm, and the treatment amount can be set in a range of approximately 0.3 KV·A·minutes/$m^2$ to 0.4 KV·A·minutes/$m^2$. The corona treatment is preferable since the treatment can be carried out at normal pressure in the air.

(Heating of the base material)

In addition, when a heating treatment of the base material coated with the polysilazane film is carried out at the same time as the plasma treatment, it is possible to carry out the treatment within a shorter period of time. The temperature of the heating treatment is preferably higher; however, when the characteristics of the base material are taken into account, the temperature is preferably in a range of 25°C to 1000°C, more preferably in a range of 30°C to 500°C, and still more preferably in a range of 60°C to 300°C.

(Additional treatment)

When the radiation of active energy rays or a heating treatment is additionally carried out on the silicon-containing layer (B), which has been denatured by the plasma treatment, it is possible to increase the high nitrogen concentration region in the silicon-containing layer (B).

Examples of the active energy rays include microwaves, infrared rays, ultraviolet rays, electron beams and the like, and the active energy rays are preferably infrared rays, ultraviolet rays and electron beams.

As a method for generating ultraviolet rays, similarly to what has been described above, a metal halide lamp, a high-pressure mercury lamp, a low-pressure mercury lamp, a xenon arc lamp, a carbon arc lamp, an excimer lamp, UV light lasers such as Ar-F lasers, or the like can be used.

As a method for generating infrared rays, for example, an infrared radiator or an infrared ceramic heater can be used. In addition, in a case in which an infrared radiator is used, depending on the wavelength of infrared rays being used, it is possible to use a near infrared radiator having a strong peak at a wavelength of 1.3 $\mu$m, a middle infrared radiator having a strong peak at a wavelength of 2.5 $\mu$m and a far infrared radiator having a strong peak at a wavelength of 4.5 $\mu$m.

In the radiation of the active energy rays, infrared lasers having a single spectrum are preferably used. Specific examples of the infrared lasers include gas chemical lasers such as HF, DF, HCl, DCl, HBr and DBr, and compound semiconductor lasers (radiation wavelength in a range of 2.5 $\mu$m to 20 $\mu$m) such as $CO_2$ gas lasers, $N_2O$ gas lasers, $CO_2$ gas laser, excited far infrared lasers ($NH_3$, $CF_4$ and the like), Pb(Cd)S, PbS(Se), Pb(Sn)Te and Pb(Sn)Se.

[Polymer layer (C)]

The organic acid metallic salt having a polymerizable group which configures the polymer layer (C) has a polymerizable group and an acidic functional group in the molecule.

The polymerizable group refers to a functional group that is polymerized through a chain reaction such as a vinyl group, an epoxy group, a mercapto group, an ureido group, a sulfide group, an isocyanate group, an amino group, a hydroxyl group, a halogen atom, an oxazoline group, a carbodiimide group or a derivative thereof, and the polymerizable group is particularly preferably a vinyl group or a derivative thereof.

Examples of the acidic functional group which serves as a counter anion of the metallic salt in the organic acid metallic salt include acidic hydroxyl groups such as carboxylic acids, sulfonic acids and phenolic acids, and mercapto acids, and the acidic functional group is preferably a carboxylic acid, a sulfonic acid or a mercapto acid, and more preferably a carboxylic acid or a sulfonic acid.

The polymer layer (C) can be obtained by forming a film containing the organic acid metallic salt having a polymerizable group which is a monomer, and then polymerizing the organic acid metallic salt using ultraviolet rays, electron beams or heat. In addition, it is also possible to form a film comprised of a low polymer, that is, a polymer having a low degree of polymerization of the organic acid metallic salt having a polymerizable group and then to form the polymer layer (C) by polymerizing the organic acid metallic salt using ultraviolet rays, electron beams or heat.

The low molecular polymer has a degree of polymerization of preferably less than 20, and is more preferably a monomer or a polymer having a degree of polymerization that is equal to or lower than 10.

It is possible to form the polymer layer (C) by applying the organic acid metallic salt having a polymerizable group or the low molecular polymer thereof into a film shape as described below, and then curing the organic acid metallic salt or the low molecular polymer using heat or energy radiation.

Furthermore, it is also possible to form the polymer layer (C) by polymerizing the organic acid metallic salt having a polymerizable group using heat or energy radiation in advance, applying a solution of the obtained polymer so as to form a film, and then drying by removing the solvent.

The organic acid metallic salt having a polymerizable group is not particularly limited, and examples of a polymerizable carboxylic acid compound that can be preferably used include carboxylic acid compounds having a polymerizable vinyl group such as acrylic acid, methacrylic acid, maleic acid, itaconic acid or a derivative thereof. The carboxylic acid compound may be solely used or a mixture of two or more compounds may be used.

The organic acid metallic salt having a polymerizable group is not particularly limited, and examples of a polymerizable sulfonic acid compound that can be preferably used include sulfonic acid compounds having a polymerizable vinyl group such as vinyl sulfonic acid, allyl sulfonic acid, methallyl sulfonic acid, acrylate sulfonic acid, acrylamide sulfonic acid, methacrylate sulfonic acid, styrene sulfonic acid, isoprene sulfonic acid or a derivative thereof. The sulfonic acid compound may be solely used or a mixture of two or more compounds may be used.

The organic acid metallic salt having a polymerizable group may be a mixture of two or more elected from the carboxylic acid compounds and the sulfonic acid compounds which have a polymerizable group.

A metallic compound that forms the metallic salt used in the invention is comprised of a di- or more-valent metallic compound, a monovalent metallic compound, or a mixture thereof.

(Di- or more-valent metallic compound)

The di- or more-valent metallic compound refers to metals which belong to Groups 2A to 7A, 1B to 3B and 8 in the periodic table and compounds thereof, and specific examples include metals having a valence that is equal to or larger than two such as magnesium (Mg), calcium (Ca), strontium (Sr), barium (Ba), iron (Fe), cobalt (Co), nickel (Ni), copper (Cu), zinc (Zn) and aluminum (Al), oxides of the above-described metals, hydroxides, halides, carbonates, phosphates, phosphites, hypophosphites, sulfates, sulfites and the like. Among the above-described metallic compounds, the di- or more-valent metallic compounds are preferable, and magnesium oxide, calcium oxide, barium oxide, zinc oxide, magnesium hydroxide, calcium hydroxide, barium hydroxide, zinc hydroxide and the like are particularly preferable. In a case in which a di- or more-valent metallic compound is used, the gas barrier property of a film obtained by polymerizing a salt of the unsaturated carboxylic acid compound at a high humidity is excellent. At least one di- or more-valent metallic compound needs to be used, and the di- or more-valent metallic compound may be solely used, or two or more compounds may be jointly used. Among the above-described di- or more-valent metallic compounds, Mg, Ca, Zn and Ba are preferable, and Zn is particularly preferable.

(Monovalent metallic compound)

The monovalent metallic compound refers to metals which belong to Group 1A in the periodic table, that is, alkali metals and compounds thereof, and specific examples include monovalent metals such as lithium (Li), sodium (Na) and potassium (K), oxides of the above-described metals, hydroxides, halides, carbonates, phosphates, phosphites, hypophosphites, sulfates, sulfites and the like. More specific examples are lithium oxide, sodium oxide, potassium oxide, lithium hydroxide, sodium hydroxide, potassium hydroxide and the like.

In a case in which the monovalent metallic compound is jointly used with the di- or more-valent metallic compound as the metallic compound, a film polymerized a metallic salt of the unsaturated carboxylic acid compound does not only have a favorable gas barrier property at a low humidity but also has an excellent gas barrier property at a high humidity. At least one monovalent metallic compound needs to be used, and the monovalent metallic compound may be solely used, or two or more compounds may be jointly used. Among the above-described monovalent metallic compounds, lithium (Li) or sodium (Na) is particularly preferable.

Meanwhile, the polymer layer (C) formed of a compound that is comprised of the above-described polymerizable group and the organic acid metallic salt may contain an unsaturated carboxylic acid ester compound such as methyl (meth)acrylate or ethyl (meth)acrylate; a monomer or a compound having a low molecular weight such as a vinyl ester compound such as vinyl acetate or the like; a water-soluble polymer such as polyvinyl alcohol, a copolymer of ethylene and vinyl alcohol, polyvinyl pyrrolidone, polyvinyl ethyl ether, polyacrylamide, polyethylene imine, starch, gum arabic or methyl cellulose; an acrylic acid ester polymer; a copolymer of ethylene and acrylic acid; polyvinyl acetate; a copolymer of ethylene and vinyl acetate; a compound having a high molecular weight such as polyester, polyurethane or an epoxy resin; and the like as long as the purpose of the invention is not impaired.

In addition, a pretreatment such as a corona treatment, a glow discharge treatment, a near atmospheric pressure plasma treatment, a low-pressure plasma treatment or an ultraviolet ozone treatment using a mercury lamp or an excimer lamp may be carried out on the surface of the silicon-containing layer (B) before the provision of the polymer layer (C) of a metallic salt on the layer (B). Among the above-described treatments, the corona treatment and the ultraviolet ozone treatment are preferable. The conditions of the corona treatment are not particularly limited, and, for example, discharge frequencies in a range of 5 kHz to 40 kHz and approximately in a range of 10 kHz to 30 kHz can be used, and alternating current sine waves can be used as a wave shape. The clearance of the gap between the electrode and the dielectric roll can be set in a range of 0.1 mm to 10 mm and approximately in a range of 1.0 millimeter to 2.0 mm, and the treatment amount can be set in a range of approximately $0.3KV \cdot A \cdot minutes/m^2$ to $0.4KV \cdot A \cdot minutes/m^2$. The corona treatment is preferable since the treatment can be carried out at normal pressure in the air.

Examples of a method for forming the polymer layer (C) obtained from the organic acid metallic salt having a polymerizable group or a polymer containing the organic acid metallic salt include a method in which a compound comprised of a polymerizable group and the organic acid metallic salt is dissolved in a solvent and then a solution of the mixture is applied, a method in which the above-described metallic compound adds to a solution obtained by dissolving a compound comprised of a polymerizable group and an organic acid in a solvent to product a solution containing a monovalent metallic salt and a di- or more-valent metallic salt, and the solution is applied, and then these compounds are polymerized using ultraviolet rays, electron beams or heat, thereby forming the polymer layer (C), and the like, but the method for forming the polymer layer is not limited.

Examples of a method for applying the polymer layer (C) obtained from a compound comprised of a polymerizable group and the organic acid metallic salt or a polymer containing the above-described compound to the silicon-containing layer (B) in the laminate include coating methods using a variety of well-known coating machines such as a gravure coater such as an air knife coater, a direct gravure coater, gravure offset, an arc gravure coater, gravure reverse or a jet nozzle-type gravure coater; a reverse roll coater such as a top feed reverse coater, a bottom feed reverse coater or nozzle feed reverse coater; a five-roll coater, a lip coater, a bar coater, a bar reverse coater and a die coater.

When the organic acid metallic salt having a polymerizable group is dissolved, an unsaturated carboxylic acid ester compound such as methyl (meth)acrylate or ethyl (meth)acrylate; a monomer or a compound having a low molecular weight such as a vinyl ester compound such as vinyl acetate or the like; a water-soluble polymer such as polyvinyl alcohol, a copolymer of ethylene and vinyl alcohol, polyvinyl pyrrolidone, polyvinyl ethyl ether, polyacrylamide, polyethylene imine, starch, gum arabic or methyl cellulose; an acrylic acid ester polymer; a copolymer of ethylene and acrylic acid; polyvinyl acetate; a copolymer of ethylene and vinyl acetate; a compound having a high molecular weight such as polyester or polyurethane; and the like may be added as long as the purpose of the invention is not impaired.

In addition, when the organic acid metallic salt having a polymerizable group is dissolved, a variety of additives such as a lubricant, a slip agent, an anti-blocking agent, an antistatic agent, an antifog additive, a dye, a pigment and an inorganic or organic filler may be added as long as the purpose of the invention is not impaired, and a variety of surfactants and the like may be added to improve the wettability with the silicon-containing layer (B).

In addition, when the organic acid metallic salt having a polymerizable group is dissolved, a silane coupling agent may be added to improve the adhesiveness with the polysilazane film.

The silane coupling agent is preferably a (meth)acryl-based silane coupling agent. Specific examples of the (meth)acryl-based silane coupling agent include

3-methacryloxypropylmethyldimethoxysilane,
3-methacryloxypropyltrimethoxysilane,
3-methacryloxypropylmethyldiethoxysilane,
3-methacryloxypropyltriethoxysilane,
3-acryloxypropyltrimethoxysilane and the like.

The (meth)acryl-based silane coupling agent may be used in a form of a solution obtained by hydrolyzing the coupling agent. During hydrolysis, the hydrolysis may be accelerated in an acidic condition. In addition, the solution obtained by hydrolyzing the (meth) acryl-based silane coupling agent may be diluted and then used. Examples of a diluting solvent include water, alcohols such as methanol, ethanol and 2-propanol.

The addition amount is preferably in a range of 0.1% by mass to 20% by mass with respect to the organic acid metallic salt having a polymerizable group.

The organic acid metallic salt having a polymerizable group can be polymerized using a variety of well-known methods, specifically, for example, the radiation of energy rays such as ionizing radioactive rays, heating and the like.

In a case in which energy rays are used, the energy rays are not particularly limited as long as the wavelength range is in a range of 0.0001 nm to 800 nm, and examples of the energy rays include α rays, β rays, γ rays, X rays, visible light rays, ultraviolet rays, electron beams and the like. Among the above-described energy rays, visible light rays having a wavelength range in a range of 400 nm to 800 nm, ultraviolet rays having a wavelength range in a range of 50 nm to 400 nm, and electron beams having a wavelength range in a range of 0.01 nm to 0.002 nm are preferable since the above-described rays are easily handled and apparatuses are well distributed.

In a case in which visible light rays and ultraviolet rays are used as the energy rays, a photopolymerization initiator may be added. A well-known photopolymerization initiator can be used as the photopolymerization initiator, and examples thereof include radical polymerization initiators that are manufactured and commercially available under trade names of 2-hydroxy-2methyl-1-phenyl-propane-1-one (manufactured by Ciba Specialty Chemicals K.K. Japan, trade name: DAROCUR 1173), 1-hydroxy-cyclohexyl-phenyl ketone (manufactured by Ciba Specialty Chemicals K.K. Japan, trade name: IRGACURE 184), bis(2,4,6-trimethylbenzoyl)-phenyl phosphine oxide (manufactured by Ciba Specialty Chemicals K.K. Japan, trade name: IRGACURE 819), 1-[4-(2-hydroxyethoxy)-phenyl]-2-hydroxy-2-methyl-1-propane-1-on e (manufactured by Ciba Specialty Chemicals K.K. Japan, trade name: IRGACURE 2959), a mixture of α-hydroxy ketone, acylphosphine oxide, 4-methyl benzophenone and 2,4,6-trimethyl benzophenone (manufactured by Lamberti Specialty Chemical Co., Ltd., trade name: ESACURE KT046), ESACURE KT55 (manufactured by Lamberti Specialty Chemical Co., Ltd.), 2,4,6-trimethyl benzoyl diphenyl phosphine oxide (manufactured by Lambson Fire Chemical Co., Ltd., trade name: SPEEDCURE TPO), IRGACURE 651 (manufactured by Ciba Specialty Chemicals K.K. Japan), DAROCUR 1173 (manufactured by Ciba Specialty Chemicals K.K. Japan), benzophenone, 4-phenyl benzophenone, IRGACURE 500 (manufactured by Ciba Specialty Chemicals K.K. Japan), IRGACURE 127 (manufactured by Ciba Specialty Chemicals K.K. Japan), IRGACURE 907 (manufactured by Ciba Specialty Chemicals K.K. Japan), IRGACURE 369 (manufactured by Ciba Specialty Chemicals K.K. Japan), IRGACURE 1300 (manufactured by Ciba Specialty Chemicals K.K. Japan), IRGACURE 1800 (manufactured by Ciba Specialty Chemicals K.K. Japan), DAROCUR TPO (manufactured by Ciba Specialty Chemicals K.K. Japan), DAROCUR 4265 (manufactured by Ciba Specialty Chemicals K.K. Japan), IRGACURE OXE01 (manufactured by Ciba Specialty Chemicals K. K. Japan), IRGACURE OXE02 (manufactured by Ciba Specialty Chemicals K. K. Japan), ESACURE KIP150 (manufactured by Lamberti Specialty Chemical Co., Ltd.), ESACURE KIP100F (manufactured by Lamberti Specialty Chemical Co., Ltd.), ESACURE KT37 (manufactured by Lamberti Specialty Chemical Co., Ltd.), ESACURE KTO46 (manufactured by Lamberti Specialty Chemical Co., Ltd.), ESACURE 1001M (manufactured by Lamberti Specialty Chemical Co., Ltd.), ESACURE KIP/EM (manufactured by Lamberti Specialty Chemical Co., Ltd.), ESACURE DP250 (manufactured by Lamberti Specialty Chemical Co., Ltd.), ESACURE KB1 (manufactured by Lamberti Specialty Chemical Co., Ltd.), 2,4-diethyl thioxanthone or the like. Furthermore, a polymerization accelerator can be added to improve the degree of polymerization or the polymerization rate, and examples thereof include N,N-dimethylamino-ethyl-(meth)acrylate, N-(meth)acryloyl-morpholine, 2,2-bis(2-chlorophenyl)-4,4', 5,5'-tetraphenyl-1,2'-biimidazole, tris(4-dimethylaminophenyl)methane, 4,4'-bis(dimethylamino)benzophenone, 2,-ethylanthraquinone, camphorquinone, and the like.

In a case in which a thermal treatment is carried out to make progress in polymerization using heat, a thermal polymerization initiator may be used.

Examples of the thermal polymerization initiator include persulfates, azo-based polymerization initiators, peroxides and aqueous hydrogen peroxide. In a case in which the thermal polymerization initiator is used, the thermal polymerization initiator is added to a polymerizable composition at a range of, generally, 0.001% by weight to 10% by weight, and, preferably, 0.01% by weight to 5% by weight.

In addition, when the radiation of energy rays or a thermal treatment is additionally carried out on the laminate of the invention after the above-described steps, it is possible to further improve the gas barrier property.

In a case in which the energy rays are used, the energy rays are not particularly limited as long as the wavelength range is in a range of 0.0001 nm to 800 nm, and examples of the energy rays include α rays, β rays, γ rays, X rays, visible light rays, ultraviolet rays, electron beams and the like. Among the above-described ionizing radioactive rays, ultraviolet rays in a range of 50 nm to 400 nm and electron beams in a range of 0.01 nm to 0.002 nm are preferable.

Examples of the thermal treatment for accelerating the polymerization using heat include a thermal treatment using heat transfer by convection (for example, a dryer or an oven), a thermal treatment using heat transfer by conduction (for example, a heating roll), a thermal treatment using heat transfer by radiation (for example, a thermal treatment using electromagnetic waves of a heater of infrared rays, far infrared rays or near infrared rays or the like), and a thermal treatment using internal heat generation (for example, microwaves). In the case of the thermal treatment using an oven, while also depending on the type of the film base material, the thermal treatment is generally carried out at a temperature in a range of approximately 60°C to 350°C for approximately 1 minute to 5 hours, and is particularly desirably carried out at a temperature in a range of 100°C to 200°C for 5 minutes to 2 hours. In a case in which the laminate is continuously heated, a treatment using a heating roll and a far infrared furnace is effective due to the high treatment rate. In addition, the above-described radiation of energy rays or thermal treatment may be carried out at a reduced pressure.

On at least one surface of the laminate of the invention, a thermoset resin layer, an ultraviolet curable resin layer, a hard coat resin layer, an easily slipping layer, a conductive layer, a thermally fused layer and a functional element-sealing resin layer, which will be described below, may be further laminated in accordance with the intended use. A single layer, a combination of the layers, and several layers may be laminated.

[Thermoset resin layer, ultraviolet curable resin layer and hard coat resin layer]

These layers can be formed by coating an ordinary thermoset resin layer, ultraviolet curable resin layer or hard coat resin layer and by crosslinking using heating, ultraviolet rays, electron beams or the like. Specific examples include (meth) acryl resins, epoxy resins and the like. In addition, the above-described resin may be solely used, and may be jointly used if necessary.

In a case in which the layers are used after being cured using ultraviolet rays, a photo radical initiator, a photocationic initiator, a photo-acid-generating agent, and, additionally, a photosensitizer are preferably mixed with the layers.

In addition, a variety of additives such as a lubricant, a slip agent, an anti-blocking agent, an antistatic agent, an antifog additive, a dye, a pigment and an inorganic or organic filler may be added, and a variety of surfactants and the like may be added to the thermoset resin layer, the ultraviolet curable resin layer and the hard coat resin layer.

[Conductive layer]

A laminate film that is preferable as an electronic member can be obtained by laminating a conductive metal, a conductive ceramic or a conductive carbon material. The metal is not particularly limited, but metals such as gold, silver, platinum, copper and lead are preferable. Indium tin oxide, zinc oxide, titanium oxide and the like can be used as the ceramic.

Graphite, carbon nanotubes, graphene and the like can be used as the carbon material.

The conductive layer can be obtained by applying a paste-form coating solution in which the fine particles of the above-described metal, ceramic or carbon material are dispersed in water or an organic solvent, or by producing a thin film of the metal, ceramic or carbon material using a vapor-phase deposition method such as deposition or sputtering.

[Thermally fused layer]

When a thermally fused layer is laminated, a laminated film that is preferable as a heat-sealable packaging film can be obtained. Generally, the thermally fused layer is obtained from a single composition, two or more compositions of a polyolefin such as a well-known monopolymer or copolymer of an $\alpha$-olefin such as ethylene, propylene, butene-1, hexene-1,4-methyl·pentene-1 or octene-1; low density polyethylene obtained using a high pressure method, linear low density polyethylene (so-called LLDPE), high density polyethylene, polypropylene, a polypropylene random copolymer, polybutene, poly4-methyl·pentene-1, a poorly crystalline or amorphous ethylene·propylene random copolymer, an ethylene·butene-1 random copolymer, or a propylene·butene-1 random copolymer, a copolymer of ethylene and vinyl acetate (EVA), a copolymer of ethylene and (meth) acrylic acid or a metallic salt thereof, a composition of EVA and polyolefin, or the like.

Among the above-described thermally fused layers, a thermally fused layer obtained from low density polyethylene obtained using a high pressure method, linear low density polyethylene (so-called LLDPE) or high density polyethylene is preferable since the low temperature heat sealing property and the heat sealing strength are excellent.

The thickness of the thermally fused layer is generally in a range of approximately 1 $\mu$m to 50 $\mu$m.

<Electronic member>

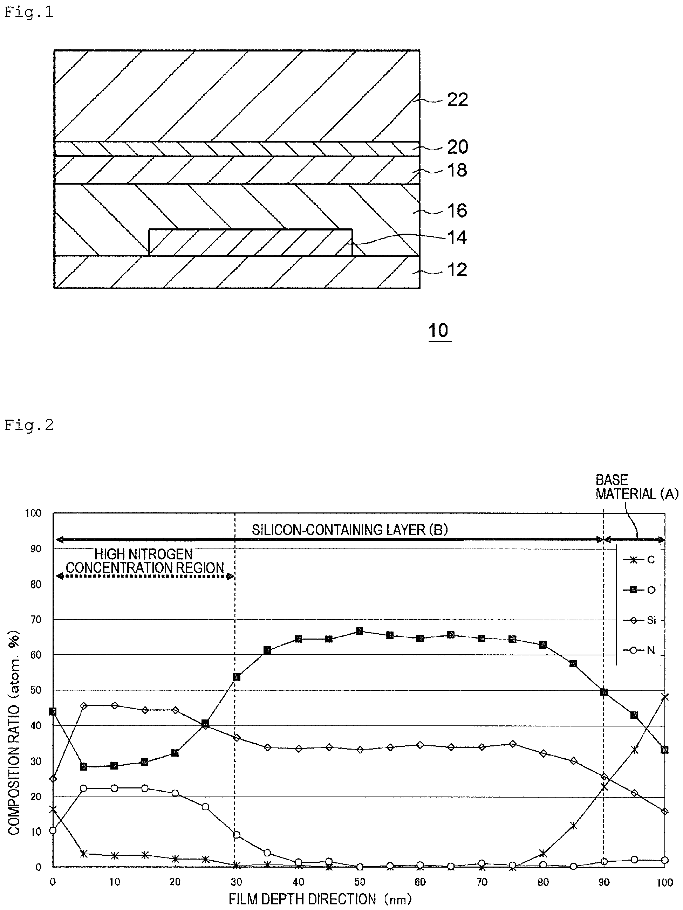

An electronic member 10 of the invention is formed by disposing the laminate of the invention which is composed of a base material (A) 22, a silicon-containing layer (B) 20 and a polymer layer (C) 18 on a member which is composed of a base material 12 comprised of glass or a resin, an element 14 mounted on the base material 12, and a functional element-sealing resin layer 16 that covers the base material 12 and the element 14 so that the polymer layer (C) 18 faces the member as illustrated in FIG. 1.

[Element]

Examples of the element 14 include elements such as a liquid crystal display element and an organic EL, organic functional elements such as a planar light emitter and an optical device, and inorganic functional elements such as an inorganic EL. The laminate of the invention can be effectively used in organic ELs which require a high degree moisture and oxygen barrier.

[Functional element-sealing resin layer]

The functional element-sealing resin layer 16 is a resin layer that seals the element 14. The functional element-sealing resin layer 16 is not particularly limited, and a heat-sealable thermoplastic resin or the above-described thermoset resin or ultraviolet curable resin (hereinafter, both resins will be, sometimes, referred to as "curable resin") can be used.

The functional element-sealing resin layer 16 can be adhered to and laminated on the polymer layer (C) 18 in the laminate of the invention. It is possible to use a curable resin, if necessary, as an adhesion layer between the polymer layer (C) 18 and the sealing resin layer 16.

The laminate of the invention can be effectively used in organic ELs. The functional element-sealing resin layer 16 can be used as an organic EL-sealing resin layer. As the organic EL-sealing resin layer, a well-known thermosetting resin or ultraviolet curable resin, such as an acrylate or epoxy resin, or a heat-sealable thermoplastic resin can be used.

A thermoplastic resin used in the heat-sealable thermoplastic resin layer is not particularly limited, and preferable examples thereof include low density polyethylene; LLDPE which is a random copolymer of ethylene and an $\alpha$-olefin having 4 to 8 carbon atoms; copolymer elastomers of ethylene and an $\alpha$-olefin such as a copolymer of ethylene and propylene, a copolymer of ethylene and 1-butene, ethylene-1-hexene copolymers and 1-octene copolymers; propylene-based elastomers such as a copolymer of propylene and ethylene and a copolymer of propylene, ethylene and 1-butene; butene-based elastomers such as a copolymer of butene and ethylene; and copolymers of ethylene and a polar monomer such as a copolymer of ethylene and vinyl acetate and a copolymer of ethylene and acrylic acid.

The preferable examples that are denatured using a polar group-containing monomer such as acrylic acid, maleic acid, maleic acid anhydride or an epoxy group-containing monomer may be also used as the thermoplastic resin. The heat-sealable thermoplastic resin can be laminated through lamination or can be formed as a coated layer through coating.

Examples of a coating agent for the above-described layer include ionomers such as a copolymer of ethylene and vinyl acetate, a copolymer of ethylene and acetate vinyl, a copolymer of ethylene and acrylic acid, and a copolymer of ethylene and sodium methacrylate.

The heat-sealable thermoplastic resin layer can be used with no particular limitation as long as the heat-sealable thermoplastic resin layer can be fused and fixed to another material through heating and fusion as described above. Among the above-described materials, polyolefins such as polyethylene and polypropylene which are obtained by grafting acrylic acid, maleic acid anhydride or a derivative thereof are preferable as a material for the heat-sealable thermoplastic resin layer.

Between the polymer layer (C) 18 and the sealing resin layer 16, a curable resin as an additional adhesion layer if necessary can be used to adhere these layers. That is, a configuration of the base material (A)/the silicon-containing layer (B)/the polymer layer (C) / (the adhesion layer) /the organic EL-sealing resin can be obtained. When the above-described configuration is formed, a high degree moisture and oxygen barrier property and high degree EL element-protection performance can be obtained, which is preferable.

[Examples]

Next, the invention will be more specifically described using examples, but the invention is not limited to the examples by any means.

Property values in the examples and comparative examples were obtained using the following evaluation methods.

<Evaluation methods>

(1) Oxygen transmission rate [ml/(m$^2$·day·atm)] : the oxygen transmission rate of the laminate was measured using an OX-TRAN 2/20 manufactured by Mocon, Inc. based on JIS K 7126 under the conditions of a temperature of 23°C and a humidity of 90%R.H.

(2) Water vapor transmission rate [ml/(m$^2$·day)] : the water vapor transmission rate of the laminate was measured using a Ca corrosion method water vapor transmission tester US710 manufactured by Sentec Corp, Ltd. Calcium was deposited on a single surface of the laminate in a vacuum, then, aluminum was deposited in a vacuum to a thickness of 1000 nm so as to fully cover the calcium, and a glass sheet was attached to the deposited surface using a heat-resistant adhesive, thereby producing a sample. The sample was placed in an atmosphere of a temperature of 60°C and a humidity of 90%R.H., corrosion spots in calcium hydroxide formed by a reaction between water vapor which had transmitted from the opposite side of the calcium/aluminum-coated surface of the laminate and the calcium were observed using a tester, and the amount of transmitted water vapor was computed using an increase rate of the area of the corrosion spots over time.

(3) The analysis of the film structure and the measurement of the element composition ratio

The composition ratio of the constituent elements in the silicon-containing layer (B) in the film depth direction was measured using an X-ray photoelectron spectroscope (XPS) ("ESCALAB 220iXL" manufactured by VG Scienta) (Al-K$\alpha$ X-ray source, 0.05 nm/sputter second in terms of argon sputter $SiO_2$).

(4) Bending test (bend resistance test)

A column having a radius of 5 mm was placed at the center of a film (10 cm x 10 cm) of the laminate of each of the examples and the comparative examples, and the film was bent at 135° at a side surface of the column as a supporting point. After the above-described operation was repeated 100 times, the appearance of the film was visually observed. Subsequently, the oxygen transmission rate was measured using the above-described evaluation method.

The outline of a plasma treatment apparatus used when producing the silicon-containing layers (B) of Examples 1 to 10 and Comparative Examples 3, 5 and 6 are as follows.

(1) Low-pressure capacitively-coupled plasma treatment apparatus (manufactured by YOUTEC Co., Ltd.)

This is a parallel plate electrode-type low-pressure capacitively-coupled plasma treatment apparatus in which a SUS vacuum container is used. One electrode is connected to a radio-frequency power supply through a matching box, and the other facing electrode is grounded. The electrode gap was set to 70 mm. The polysilazane film was installed in the grounded electrode, and a treatment was carried out. In addition, the density of the injected power was obtained using the area of the radio-frequency electrode surface facing the grounded electrode as the area of the plasma source. Furthermore, the temperature of the electrode can be adjusted using the flow of a liquid, and it is possible to heat the base material of the polysilazane film.

(2) Low-pressure inductively-coupled plasma treatment apparatus (ICP type)

This is an outer antenna-type low-pressure inductively-coupled plasma treatment apparatus in which a single-loop antenna coil is installed in a SUS cylindrical vacuum chamber through a silica dielectric window. The entire top surface of the vacuum chamber serves as a source of inductively-coupled plasma. Therefore, the area of the plasma source was computed using the inner diameter of the vacuum chamber, and the density of the injected power was obtained. One end of the antenna coil is connected to a radio-frequency power supply through a matching box, and the other end is grounded. The polysilazane film was installed on a specimen table 200 mm away from the dielectric window.

(3) Dielectric barrier discharge-type plasma treatment apparatus

This is a parallel plate electrode-type dielectric barrier discharge-type plasma treatment apparatus in which a glass vacuum container is coated with glass. One electrode is connected to an impulse-type high-voltage power supply, and the other facing electrode is grounded. The electrode gap was set to 5 mm. The polysilazane film was installed in the grounded electrode, and a treatment was carried out. In addition, the density of the injected power was obtained using the area of the high-voltage electrode surface facing the grounded electrode as the area of the plasma source.

<The production of a coating solution for the preparation of the polymer layer (C)>

<The production of a solution (W)>

A photopolymerization initiator [1-[4-(2-hydroxyethoxy)-phenyl]-2-hydroxy-2-methyl-1-propane-1-o ne (manufactured by Ciba Specialty Chemicals K.K. Japan, trade name: IRGACURE 2959)] which had been diluted to 25% by weight using methyl alcohol and a surfactant (manufactured by Kao Corporation, trade name: EMULGEN 120) were added to an aqueous solution of zinc acrylate (a Zn salt of acrylic acid) (manufactured by Asada Chemical Industry Co., Ltd., a concentration of 30% by weight (acrylic acid component: 20% by weight, Zn component: 10% by weight)) at ratio of respectively 2% and 0. 4% as the solid contents with respect to acrylic acid , thereby producing a Zn salt solution (W) of an unsaturated carboxylic acid.

<The production of a solution (X)>

Acrylic acid (monomer) (manufactured by Kyoeisha Chemical Co., Ltd.) was diluted using water, thereby producing a 25% aqueous solution. The same number of moles of lithium hydroxide monohydrate (manufactured by Kanto Chemical Co., Inc.) to the carboxylic groups in the acrylic acid in the aqueous solution was added, thereby producing an aqueous solution of lithium acrylate (a Li salt of acrylic acid). Next, a photopolymerization initiator [1-[4-(2-hydroxyethoxy)-phenyl]-2-hydroxy-2-methyl-1-propane-1-o ne (manufactured by Ciba Specialty Chemicals K.K. Japan, trade name: IRGACURE 2959)] which had been diluted to 25% by weight using methyl alcohol and a surfactant (manufactured by Kao Corporation, trade name: EMULGEN 120) were added to the produced aqueous solution of lithium acrylate at ratio of respectively 2% and 0.4% as the solid contents with respect to acrylic acid, thereby producing a solution (X) of the lithium salt of unsaturated carboxylic acid.

<The production of a solution (Y)>

Acrylic acid (monomer) (manufactured by Kyoeisha Chemical Co., Ltd.) was diluted using water, thereby producing a 25% aqueous solution. The same mole of sodium hydroxide (manufactured by Kanto Chemical Co., Inc.) to the carboxylic group in the acrylic acid in the aqueous solution was added, thereby producing an aqueous solution of sodium acrylate (a Na salt of acrylic acid). Next, a photopolymerization initiator [1-[4-(2-hydroxyethoxy)-phenyl]-2-hydroxy-2-methyl-1-propane-1-o ne (manufactured by Ciba Specialty Chemicals K.K. Japan, trade name: IRGACURE 2959)] which had been diluted to 25% by weight using methyl alcohol and a surfactant (manufactured by Kao Corporation, trade name: EMULGEN 120) were added to the produced aqueous solution of sodium acrylate at ratio of respectively 2% and 0.4% as the solid contents with respect to acrylic acid, thereby producing a solution (Y) of the sodium salt of an unsaturated carboxylic acid.

<The production of a solution (Z): a solution of hydrolyzed 3-acryloxypropyltrimethoxysilane>

Purified water (34.46 g) was added to 3-acryloxy propyl trimethoxysilane (manufactured by Shin-Etsu Chemical Co., Ltd., trade name: KBM 5103, 10 g), acetic acid (0.25 g) was added, the components were stirred for 20 minutes, and then isopropyl alcohol (34.46 g) was added, thereby obtaining a solution (Z) of a solution of hydrolyzed 3-acryloxypropyltrimethoxysilane.

<The production of a solution (A)>

The above-described solution (W) of the zinc salt of the unsaturated carboxylic acid and the above-described solution (X) of the lithium salt of the unsaturated carboxylic acid were mixed at a ratio of 75:25 (molar ratio), thereby obtaining a solution (A).

<The production of a solution (B)>

The above-described solution (W) of the zinc salt of the unsaturated carboxylic acid and the above-described solution (Y) of the sodium salt of the unsaturated carboxylic acid were mixed at a ratio of 75:25 (molar ratio), thereby obtaining a solution (B).

<The production of a solution (C)>

An aqueous solution of sodium 2-acrylamido-2-methylpropane sulfonate (ATBS manufactured by Toagosei Co. , Ltd.) was diluted using water, thereby producing a 25% aqueous solution. Next, a photopolymerization initiator [1-[4-(2-hydroxyethoxy)-phenyl]-2-hydroxy-2-methyl-1-propane-1-o ne (manufactured by Ciba Specialty Chemicals K.K. Japan, trade name: IRGACURE 2959)] which had been diluted to 25% by weight using methyl alcohol was added at the ratio of 2% as the solid content, thereby producing a solution (C) of the sodium salt of a polymerizable sulfonic acid compound.

<The production of a solution (D)>

The above-described solution (A) and 3-acryloxypropyltrimethoxysilazane (Z) were mixed at a ratio of 98:2 (weight ratio), thereby obtaining a solution (D).

<Example 1>

4.5 wt% xylene (dehydrated) solution of polysilazane (NL 110A, manufactured by AZ Electronic Materials) was bar-coated on a polyethylene terephthalate (PET) film (thickness of 50 $\mu$m, "A4100", manufactured by Toyobo Co., Ltd.) which served as the base material (A), and was dried at 150°C for 90 seconds, thereby producing a 0.15 $\mu$m-thick polysilazane film.
A low-pressure plasma treatment was carried out on the polysilazane film under the following conditions, thereby producing a silicon-containing layer (B).

Vacuum plasma treatment apparatus: low-pressure capacitively-coupled plasma treatment apparatus (manufactured by YOUTEC Co., Ltd.)

Gas: He
Gas flow rate: 50 mL/min
Pressure: 19 Pa
Density of the injected power: 1.3 W/cm$^2$
Frequency: 13.56 MHz
Treatment time: 30 seconds
Oxygen concentration: equal to or lower than 1 ppm
Water vapor concentration: equal to or lower than 1 ppm

After that, the solution (A) was applied to the produced silicon-containing layer (B) so as to be 2.8 g/m$^2$, and was dried using a hot-air dryer under the conditions of a humidity of 60% and a time of 30 seconds. After that, the silicon-containing layer was rapidly fixed to a stainless steel sheet with the coated surface facing upward, was polymerized by irradiating ultraviolet rays using an UV radiator (manufactured by Eye Graphic Co., Ltd., EYE GRANDAGE-type ECS 301G1) under conditions of an UV intensity of 190 mW/cm$^2$ and an integrated light volume of 250 mJ/cm$^2$, and then the obtained gas barrier laminate film was mounted on a hot plate so as to carry out a heating treatment, thereby obtaining a laminate. The conditions of the heating treatment are a temperature of the hot plate of 200°C and a holding time of 60 minutes.

The XPS measurement results of the silicon-containing layer (B) obtained by carrying out a low-pressure plasma treatment are illustrated in FIG. 2, and, the property measurement results of the obtained laminate are described in Table 1. N/(N+O) at a depth at which the content of oxygen became largest was computed based on the XPS chart of the silicon-containing layer (B).

Meanwhile, as a result of arbitrarily selecting a plurality of places and carrying out XPS measurements, it was confirmed that a high nitrogen concentration region was formed throughout the entire surface of the silicon-containing layer (B) from the fact that the same results as the measurement values in FIG. 2 were obtained in all places.

<Example 2>

Urethane acrylate (urethane acrylate-based UV curable coating material (manufactured by Shin-Nakamura Chemical Co., Ltd., trade name: UA-100)) was diluted using ethyl acetate, and was applied on a polyethylene terephthalate (PET) film (thickness of 50 μm, "A4100", manufactured by Toyobo Co., Ltd.) which served as the base material (A) using a Meyer bar so as to be 1.2 g/m$^2$ (solid content), and was dried at 100°C for 15 seconds. Subsequently, the coated surface was photocured using an UV radiator (manufactured by Eye Graphic Co., Ltd., EYE GRANDAGE-type ECS 301G1) under conditions of an UV intensity of 250 mW/cm$^2$ and an integrated light volume of 117 mJ/cm$^2$, and an undercoat layer was provided. Furthermore, a 4.5 wt% xylene (dehydrated) solution of polysilazane (NL 110A, manufactured by AZ Electronic Materials) was bar-coated on the undercoat layer, and was dried at 150°C for 90 seconds, thereby producing a 0.15 μm-thick polysilazane film. After that, the same operation as in Example 1 was carried out, thereby obtaining a laminate. The property measurement results of the obtained laminate are described in Table 1.

<Example 3>

The solution A used in Example 2 was changed to the solution B, and the same operation as in Example 2 except for the above-described change was carried out, thereby obtaining a laminate. The property measurement results of the obtained laminate are described in Table 1.

<Example 4>

The solution A used in Example 2 was changed to the solution C, and the same operation as in Example 2 except for the above-described change was carried out, thereby obtaining a laminate. The property measurement results of the obtained laminate are described in Table 1.

<Example 5>

The solution A used in Example 2 was changed to the solution D, and the same operation as in Example 2 except for the above-described change was carried out, thereby obtaining a laminate. The property measurement results of the obtained laminate are described in Table 1.

<Example 6>

Coating and drying were carried out in the same manner as in Example 2 so as to prepare a polysilazane film, and a low-pressure plasma treatment was carried out by changing the conditions of Example 2 to the following conditions.
Vacuum plasma treatment apparatus: low-pressure capacitively-coupled plasma treatment apparatus (manufactured by YOUTEC Co., Ltd.)

Gas: Ar
Gas flow rate: 50 mL/min
Pressure: 19 Pa
Power applied to the unit area of the electrode: 1.3 W/cm$^2$
Frequency: 13.56 MHz
Treatment time: 5 minutes
Oxygen concentration: equal to or lower than 1 ppm
Water vapor concentration: equal to or lower than 1 ppm

After that, a polymer layer (C) was formed on a silicon-containing layer (B) in the same manner as in Example 2, thereby obtaining a laminate. The property measurement results of the obtained laminate are described in Table 1.

<Example 7>

Coating and drying were carried out in the same manner as in Example 2 so as to prepare a polysilazane film, and a low-pressure plasma treatment was carried out by changing the conditions of Example 2 to the following conditions.
Vacuum plasma treatment apparatus: low-pressure capacitively-coupled plasma treatment apparatus (manufactured by YOUTEC Co., Ltd.)

Gas: He+H$_2$ (H$_2$ concentration: 6 vol%)
Total pressure: 19 Pa
Density of the injected power: 1.3 W/cm$^2$
Frequency: 13.56 MHz
Treatment time: 60 seconds
Oxygen concentration: equal to or lower than 1 ppm
Water vapor concentration: equal to or lower than 1 ppm

After that, a polymer layer (C) was formed on a silicon-containing layer (B) in the same manner as in Example 2, thereby obtaining a laminate. The property measurement results of the obtained laminate are described in Table 1.

<Example 8>

Coating and drying were carried out in the same manner as in Example 2 so as to prepare a polysilazane film, and a low-pressure plasma treatment was carried out by changing the conditions of Example 2 to the following conditions.

Plasma treatment apparatus: low-pressure capacitively-coupled plasma treatment apparatus (manufactured by U-TEC)
Gas: Ar+H$_2$ (H$_2$ concentration: 6 vol%)
Total pressure: 19 Pa
Density of the injected power: 1.3 W/cm$^2$
Frequency: 13.56 MHz
Treatment time: 30 seconds
Oxygen concentration: equal to or lower than 1 ppm
Water vapor concentration: equal to or lower than 1 ppm

After that, a polymer layer (C) was formed on a silicon-containing layer (B) in the same manner as in Example 2, thereby obtaining a laminate. The property measurement results of the obtained laminate are described in Table 1.

<Example 9>

Coating and drying were carried out in the same manner as in Example 2 so as to prepare a polysilazane film, and a low-pressure plasma treatment was carried out by changing the conditions of Example 2 to the following conditions.

Plasma treatment apparatus: low-pressure inductively-coupled plasma treatment apparatus (manufactured by the inventors) (ICP type)

Gas: $He+H_2$ ($H_2$ concentration: 6 vol%)

Total pressure: 20 Pa

Density of the injected power: 2 $W/cm^2$ (4000 W, area of the plasma source: $\phi$250 mm)

Frequency: 13.56 MHz

Treatment time: 20 seconds

Oxygen concentration: equal to or lower than 1 ppm

Water vapor concentration: equal to or lower than 1 ppm

After that, a polymer layer (C) was formed on a silicon-containing layer (B) in the same manner as in Example 2, thereby obtaining a laminate. The property measurement results of the obtained laminate are described in Table 1.

<Example 10>

Coating and drying were carried out in the same manner as in Example 2 so as to prepare a polysilazane film, and a low-pressure plasma treatment was carried out by changing the conditions of Example 2 to the following conditions.

Plasma treatment apparatus: dielectric barrier discharge-type plasma treatment apparatus (manufactured by the inventors)

Gas: Ar

Pressure: 50 kPa

Base material heating temperature: room temperature

Density of the injected power: 0.4 $W/cm^2$

Frequency: 10 kHz

Treatment time: 600 seconds

Oxygen concentration: equal to or lower than 1 ppm

Water vapor concentration: equal to or lower than 1 ppm

After that, a polymer layer (C) was formed on a silicon-containing layer (B) in the same manner as in Example 2, thereby obtaining a laminate. The property measurement results of the obtained laminate are described in Table 1.

<Comparative Example 1>

50 nanometer (nm)-thick silicon oxynitride film was formed on a polyethylene terephthalate (PET) film (thickness of 50 $\mu$m, "A4300", manufactured by Toyobo Co., Ltd.) which served as the base material (A) using a catalytic-CVD apparatus.

After that, the solution (A) was applied so as to be 2.8 $g/m^2$, and was dried using a hot-air dryer under the conditions of a humidity of 60% and a time of 30 seconds. After that, the silicon-containing layer was rapidly fixed to a stainless steel sheet with the coated surface facing upward, was polymerized by irradiating ultraviolet rays using an UV radiator (manufactured by Eye Graphic Co., Ltd., EYE GRANDAGE-type ECS 301G1) under conditions of an UV intensity of 190 $mW/cm^2$ and an integrated light volume of 250 $mJ/cm^2$, and then the obtained gas barrier laminate film was mounted on a hot plate so as to carry out a heating treatment, thereby obtaining a laminate. The conditions of the heating treatment are a temperature of the hot plate of 200 °C and a holding time of 60 minutes. The property measurement results of the obtained laminate are described in Table 1.

<Comparative Example 2>

Urethane acrylate (urethane acrylate-based UV curable coating material (manufactured by Shin-Nakamura Chemical Co., Ltd., trade name: UA-100)) was diluted using ethyl acetate, and was applied to a polyethylene terephthalate (PET) film (thickness of 50 $\mu$m, "A4300", manufactured by Toyobo Co., Ltd.) which served as the base material (A) using a Meyer bar so as to be 1.2 $g/m^2$ (solid content), and was dried at 100°C for 15 seconds. Subsequently, the coated surface was photocured using an UV radiator (manufactured by Eye Graphic Co., Ltd. , EYE GRANDAGE-type ECS 301G1) under conditions of an UV intensity of 250 mW/cm$^2$ and an integrated light volume of 117 mJ/cm$^2$, and an undercoat layer was provided.

After that, the same operation as in Comparative Example 1 was carried out, thereby obtaining a laminate. The property measurement results of the obtained laminate are described in Table 1.

<Comparative Example 3>

Urethane acrylate (urethane acrylate-based UV curable coating material (manufactured by Shin-Nakamura Chemical Co., Ltd., trade name: UA-100)) was diluted using ethyl acetate, and was applied to a polyethylene terephthalate (PET) film (thickness of 50 μm, "A4300", manufactured by Toyobo Co., Ltd.) which served as the base material (A) using a Meyer bar so as to be 1.2 g/m$^2$ (solid content), and was dried at 100°C for 15 seconds.

A 4.5 wt% xylene (dehydrated) solution of the polysilazane (NL 110A, manufactured by AZ Electronic Materials) was bar-coated, and was dried at 150°C for 90 seconds, thereby producing a 0.15 μm-thick polysilazane film. A low-pressure plasma treatment was carried out on the polysilazane film in the same method as in Example 2. The property measurement results are described in Table 1.

<Comparative Example 4>

Urethane acrylate (urethane acrylate-based UV curable coating material (manufactured by Shin-Nakamura Chemical Co., Ltd., trade name: UA-100)) was diluted using ethyl acetate, and was applied to a polyethylene terephthalate (PET) film (thickness of 50 μm, "A4300", manufactured by Toyobo Co., Ltd.) which served as the base material (A) using a Meyer bar so as to be 1.2 g/m$^2$ (solid content), and was dried at 100°C for 15 seconds.

Without interposing the silicon-containing layer (B), the solution (A) was applied so as to be 2.8 g/m$^2$, and was dried using a hot-air dryer under the conditions of a temperature of 60°C and a time of 30 seconds. After that, the silicon-containing layer was rapidly fixed to a stainless steel sheet with the coated surface facing upward, was polymerized by irradiating ultraviolet rays using an UV radiator (manufactured by Eye Graphic Co., Ltd., EYE GRANDAGE-type ECS 301G1) under conditions of an UV intensity of 190 mW/cm$^2$ and an integrated light volume of 250 mJ/cm$^2$, and then the obtained gas barrier laminate film was mounted on a hot plate so as to carry out a heating treatment, thereby obtaining a polymer layer (C). The conditions of the heating treatment are a temperature of the hot plate of 200 °C and a holding time of 60 minutes. The property measurement results are described in Table 1.

<Comparative Example 5>

Urethane acrylate (urethane acrylate-based UV curable coating material (manufactured by Shin-Nakamura Chemical Co., Ltd., trade name: UA-100)) was diluted using ethyl acetate, and was applied to a polyethylene terephthalate (PET) film (thickness of 50 μm, "A4300", manufactured by Toyobo Co., Ltd.) which served as the base material (A) using a Meyer bar so as to be 1.2 g/m$^2$ (solid content), and was dried at 100°C for 15 seconds.

A 4.5 wt% xylene (dehydrated) solution of the polysilazane (NL 110A, manufactured by AZ Electronic Materials) was bar-coated, and was dried at 150°C for 90 seconds, thereby producing a 1.15 μm-thick polysilazane film. A low-pressure plasma treatment was carried out on the polysilazane film in the same method as in Example 2. The property measurement results are described in Table 1.

<Comparative Example 6>

Coating and drying were carried out in the same manner as in Example 2 so as to prepare a polysilazane film, and a low-pressure plasma treatment was carried out by changing the conditions of Example 2 to the following conditions.

Plasma treatment apparatus: atmospheric pressure plasma treatment apparatus (APT-02, manufactured by Sekisui Chemical Co., Ltd.)

Gas: Ar
Pressure: atmospheric pressure
Base material heating temperature: room temperature (23°C)
Density of the injected power: 1.3 W/cm$^2$
Frequency: 30 kHz
Treatment time: 600 seconds
Oxygen concentration: 20% (200,000 ppm) at 23°C
Water vapor concentration: 50%RH at 23°C

After that, a polymer layer (C) was formed on a silicon-containing layer (B) in the same manner as in Example 2, thereby obtaining a laminate. The property measurement results of the obtained laminate are described in Table 1.

Table 1

| | A layer | | | B layer | | | | | | C layer | | | Total film thickness of B layer and C layer ($\mu$m) |
|---|---|---|---|---|---|---|---|---|---|---|---|---|---|
| | Type | Undercoat layer | Configuration | Forming method | Film thickness ($\mu$m) | Polysilazane denaturing method | Plasma gas | Polysilazane N/(N+O) | Solution used | Film thickness ($\mu$m) | Configuration | |
| Example 1 | PET | No | Polysilazane-denatured layer | Solution application | 0.15 | Low-pressure plasma radiation | He | 0.4 | A solution | 1.0 | Zn, Li acrylate | 1.15 |
| Example 2 | PET | Yes | Polysilazane-denatured layer | Solution application | 0.15 | Low-pressure plasma radiation | He | 0.4 | A solution | 1.0 | Zn, Li acrylate | 1.15 |
| Example 3 | PET | Yes | Polysilazane-denatured layer | Solution application | 0.15 | Low-pressure plasma radiation | He | 0.4 | B solution | 1.0 | Zn, Na acrylate | 1.15 |
| Example 4 | PET | Yes | Polysilazane-denatured layer | Solution application | 0.15 | Low-pressure plasma radiation | He | 0.4 | C solution | 1.0 | Na sulfonic acid | 1.15 |
| Example 5 | PET | Yes | Polysilazane-denatured layer | Solution application | 0.15 | Low-pressure plasma radiation | He | 0.4 | D solution | 1.0 | Zn, Li acrylate + silane coupling | 1.15 |
| Example 6 | PET | Yes | Polysilazane-denatured layer | Solution application | 0.15 | Low-pressure plasma radiation | Ar | 0.6 | A solution | 1.0 | Zn, Li acrylate | 1.15 |
| Example 7 | PET | Yes | Polysilazane-denatured layer | Solution application | 0.15 | Low-pressure plasma radiation | He+$H_2$ | 0.5 | A solution | 1.0 | Zn, Li acrylate | 1.15 |
| Example 8 | PET | Yes | Polysilazane-denatured layer | Solution application | 0.15 | Low-pressure plasma radiation | Ar+$H_2$ | 0.5 | A solution | 1.0 | Zn, Li acrylate | 1.15 |

| | Type | Undercoat layer | Configuration | Forming method | Film thickness (μm) | Polysilazane denaturing method | Plasma gas | Polysilazane N/(N+O) | Solution used | Film thickness (μm) | Configuration | |
|---|---|---|---|---|---|---|---|---|---|---|---|---|
| Example 9 | PET | Yes | Polysilazane-denatured layer | solution application | 0.15 | Low-pressure plasma radiation (ICP type) | He+$H_2$ | 0.05 | A solution | 1.0 | Zn, Li acrylate | 1.15 |
| Example 10 | PET | Yes | Polysilazane-denatured layer | Solution application | 0.15 | Near atmospheric pressure plasma radiation | Ar | 0.1 | A solution | 1.0 | Zn, Li acrylate | 1.15 |
| Comparative Example 1 | PET | No | Silicon nitride oxide layer | Dry method | 0.15 | - | - | - | A solution | 1.0 | Zn, Li acrylate | 1.15 |
| Comparative Example 2 | PET | Yes | Silicon nitride oxide layer | Dry method | 0.15 | - | | - | A solution | 1.0 | Zn, Li acrylate | 1.15 |
| Comparative Example 3 | PET | Yes | Polysilazane-denatured layer | Solution application | 0.15 | Low-pressure plasma radiation | He | 0.4 | - | - | - | 0.15 |
| Comparative Example 4 | PET | Yes | - | - | - | - | - | - | A solution | 1.15 | Zn, Li acrylate | 1.15 |
| Comparative Example 5 | PET | Yes | Polysilazane-denatured layer | Solution application | 1.15 | Low-pressure plasma radiation | He | 0.4 | - | - | - | 1.15 |
| Comparative Example 6 | PET | Yes | Polysilazane-denatured layer | Solution application | 0.15 | Near atmospheric pressure plasma radiation | Ar | 0 | A solution | 1.0 | Zn, Li acrylate | 1.15 |

EP 2 871 054 B1

(continued)

| | Oxygen transmission rate 23°C, 90%RH ml/(m²·day·atm) | Water vapor transmission rate 60°C, 90%RH g/(m²·day) | Visual observation Confirmation of the occurrence of cracking - | Bending test — Oxygen transmission rate 23°C,90%RH ml/(m²·day·atm) |
|---|---|---|---|---|
| Example 1 | <0.05 | 0.000005 | No | <0.05 |
| Example 2 | <0.05 | <0.000001 | No | <0.05 |
| Example 3 | <0.05 | 0.00008 | No | <0.05 |
| Example 4 | <0.05 | 0.00006 | No | <0.05 |
| Example 5 | <0.05 | <0.000001 | No | <0.05 |
| Example 6 | <0.05 | <0.000001 | No | <0.05 |
| Example 7 | <0.05 | <0.000001 | No | <0.05 |
| Example 8 | <0.05 | <0.000001 | No | <0.05 |
| Example 9 | <0.05 | 0.00004 | No | <0.05 |
| Example 10 | <0.05 | 0.00007 | No | <0.05 |
| Comparative Example 1 | <0.05 | 0.005 | No | <0.05 |
| Comparative Example 2 | <0.05 | 0.001 | No | <0.05 |
| Comparative Example 3 | 0.1 | 0.06 | No | 0.1 |
| Comparative Example 4 | 0.1 | 2.5 | No | 0.1 |
| Comparative Example 5 | <0.05 | 0.005 | Yes | 1.5 |

(continued)

| | Oxygen transmission rate 23°C, 90%RH ml/ (m²·day·atm) | Water vapor transmission rate 60°C, 90%RH g/ (m²·day) | Visual observation — Confirmation of the occurrence of cracking | Bending test — Oxygen transmission rate 23°C,90%RH ml/ (m²·day·atm) |
|---|---|---|---|---|
| Comparative Example 6 | 0.05 | 0.008 | - / No | 0.05 |

As shown in Table 1, the laminate of the invention was excellent in terms of the water vapor gas barrier property compared with a case in which the inorganic film produced using the dry method of Comparative Examples 1 and 2 was used as a foundation layer. In addition, in a case in which Example 1 and Comparative Example 1 were compared, a favorable gas barrier property was developed in the example even when the undercoat layer was not used on the base material (A) .

In addition, it was found from the comparison between Example 2 and Comparative Examples 3, 4 and 5 that, when three layers of the base material (A), the silicon-containing layer (B) and the polymer layer (C) were sequentially laminated as in Example 2, an extremely favorable oxygen or water vapor barrier property, which was not developed with each of the above-described layers, was synergistically developed for the first time, and favorable bend resistance was exhibited. In addition, in a case in which the silicon-containing layer had a large thickness as in Comparative Example 5, the occurrence of cracking was visually observed after the bending test, and the oxygen barrier property degraded. On the other hand, it was found that, in the laminates of Examples 1 to 10, even when the thickness was as thick as that in Comparative Example 5, cracking did not occur after the bending test, the oxygen barrier property was maintained, and the laminates were flexible. Furthermore, in a case in which the plasma treatment was carried out in a high oxygen and water vapor atmosphere as in Comparative Example 6, that is, in a case in which the silicon-containing layer (B) which contains no nitrogen so as to be N/ (N+O) =0 was used, it was confirmed that an oxygen and water vapor barrier property as favorable as in the examples was not developed.

The laminate of the invention is excellent in terms of not only the oxygen gas barrier property but also the water vapor transmission resistance, can be used for a variety of uses, such as a variety of packaging materials, medical uses and industrial uses, and, particularly, can be used for electrical and electronic materials such as sealing materials for electronic paper or liquid crystal displays, panels and sealing materials for organic ELs, and sealing materials for substrates. In addition, organic ELs to which the laminate is applicable are not particularly limited, and it is possible to use the laminate for any of passive-type organic ELs and active-type organic ELs made of a low-molecular-weight material or a high-molecular-weight material, and to use the laminate for other uses such as a variety of displays, in-vehicle mobile devices, flexible displays, lighting, advertisement display and side boards. The laminate of the invention has an excellent oxygen gas barrier property and excellent water vapor transmission resistance even when the base material is comprised of a plastic material, and can maintain the barrier properties even when being bent into a curved shape, and therefore the laminate can be preferably used for flexible displays.

## Claims

1. A laminate comprising:

   a base material (A),
   a silicon-containing layer (B) and
   a polymer layer (C) obtained from an organic acid metallic salt having a polymerizable group,

   wherein the silicon-containing layer (B) and the polymer layer (C) are sequentially laminated over at least one surface of the base material (A),
   the silicon-containing layer (B) includes a high nitrogen concentration region comprised of silicon atoms and nitrogen atoms, silicon atoms and nitrogen atoms and oxygen atoms, or silicon atoms and nitrogen atoms and oxygen atoms and carbon atoms, and
   the high nitrogen concentration region is formed by irradiating energy ray onto a polysilazane film formed over the base material (A) under an oxygen concentration equal to or lower than 5% and/or a relative humidity at room temperature (23°C) equal to or lower than 30% so as to denature at least a part of the film, wherein a composition ratio of the nitrogen atoms, which is measured using X-ray photoelectron spectroscopy and represented by the following formula (1), is in a range of 0.01 to 1 in the high nitrogen concentration region

   Formula (1): the composition ratio of the nitrogen atoms/(the composition ratio of the oxygen atoms + the composition ratio of the nitrogen atoms),

and
the organic acid metallic salt is a metallic salt of at least one selected from carboxylic acids, sulfonic acids and mercapto acids.

2. The laminate according to Claim 1,
wherein the polymer layer (C) is obtained by forming a film of the organic acid metallic salt having the polymerizable group and polymerizing the organic acid metallic salt film using ultraviolet rays, electron beams or heat over the silicon-containing layer (B) including the high nitrogen concentration region which is formed over the base material (A).

3. The laminate according to any one of Claim 1 or Claim 2,
wherein the energy ray irradiation is carried out using plasma radiation.

4. The laminate according to Claim 3,
wherein the plasma radiation is carried out under an atmosphere selected from inert gas, rare gas and reducing gas.

5. The laminate according to Claim 3 or 4,
wherein the plasma radiation is carried out at an oxygen concentration equal to or lower than 5000 ppm and a water vapor concentration (partial pressure of water vapor/ atmospheric pressure at room temperature (23°C)) equal to or lower than 8400 ppm.

6. The laminate according to any one of Claims 1 to 5,
wherein the polymerizable group is at least one selected from a vinyl group, an epoxy group, a mercapto group, an ureido group, a sulfide group, an isocyanate group, an amino group, a hydroxyl group, halogen atoms, an oxazoline group, a carbodiimide group and derivatives thereof.

7. The laminate according to any one of Claims 1 to 6,
wherein a metal that forms the organic acid metallic salt is at least one selected from lithium, sodium, magnesium, calcium, zinc and barium.

8. The laminate according to any one of Claims 1 to 7,
wherein the polymer layer (C) further contains a silane coupling agent.

9. An electronic member composed of a member including elements selected from an organic electroluminescence element, an electronic paper display element and a liquid crystal display element; and the laminate according to any one of Claims 1 to 8 provided with the polymer layer (C) facing the member.

10. A method for manufacturing a laminate comprising:

forming a polysilazane film over at least one surface of a base material (A);
irradiating energy ray onto the polysilazane film under an oxygen concentration equal to or lower than 5% and/or a relative humidity at room temperature (23°C) equal to or lower than 30% so as to denature at least a part of the film and to form a silicon-containing layer (B) including a high nitrogen concentration region comprised of silicon atoms and nitrogen atoms, silicon atoms and nitrogen atoms and oxygen atoms, or silicon atoms, nitrogen atoms, oxygen atoms and carbon atoms; and
a step of forming a polymer layer (C) obtained from an organic acid metallic salt having a polymerizable group over the silicon-containing layer (B),
wherein a composition ratio of the nitrogen atoms, which is measured using X-ray photoelectron spectroscopy and represented by the following formula (1), is in a range of 0.01 to 1 in the high nitrogen concentration region

```
Formula (1): the composition ratio of the nitrogen atoms/(the

composition ratio of the oxygen atoms + the composition ratio of the

nitrogen atoms),
```

and
the organic acid metallic salt is a metallic salt of at least one selected from carboxylic acids, sulfonic acids and mercapto acids.

11. The method for manufacturing a laminate according to Claim 10,
wherein the energy ray irradiation is carried out using plasma radiation.

12. The method for manufacturing a laminate according to Claim 11,
wherein the plasma radiation is carried out under an atmosphere gas selected from inert gas, rare gas and reducing gas.

**Patentansprüche**

1. Laminat, umfassend:

ein Basismaterial (A),
eine Silicium-enthaltende Schicht (B) und
eine Polymerschicht (C), erhalten aus einem Metallsalz einer organischen Säure mit einer polymerisierbaren Gruppe,
wobei die Silicium-enthaltende Schicht (B) und die Polymerschicht (C) der Reihe nach über mindestens eine Oberfläche des Basismaterials (A) laminiert sind,
die Silicium-enthaltende Schicht (B) einen Bereich hoher Stickstoffkonzentration enthält, der aus Siliciumatomen und Stickstoffatomen, Siliciumatomen und Stickstoffatomen und Sauerstoffatomen oder Siliciumatomen und Stickstoffatomen und Sauerstoffatomen und Kohlenstoffatomen besteht und
der Bereich hoher Stickstoffkonzentration durch Bestrahlen mit einem Energiestrahl auf eine Polysilazanschicht, die über dem Basismaterial (A) gebildet ist, bei einer Sauerstoffkonzentration von gleich oder geringer als 5% und/oder einer relativen Luftfeuchte bei Raumtemperatur (23°C) von gleich oder geringer als 30% gebildet wird, sodass mindestens ein Teil der Schicht denaturiert wird,
wobei das Zusammensetzungsverhältnis der Stickstoffatome, das mittels Röntgen-Photoelektronenspektroskopie gemessen wird und durch die folgende Formel (1) gegeben ist, im Bereich von 0,01 bis 1 im Bereich hoher Stickstoffkonzentration liegt,

```
Formel (1): das Zusammensetzungsverhältnis der
Stickstoffatome /(das Zusammensetzungsverhältnis
der Sauerstoffatome + das
Zusammensetzungsverhältnis der Stickstoffatome),
```

und
das Metallsalz einer organischen Säure ein Metallsalz mindestens einer Säure ist, die aus Carboxylsäuren, Sulfonsäuren und Mercaptosäuren ausgewählt ist.

2. Laminat gemäß Anspruch 1, wobei die Polymerschicht (C) durch Bilden einer Schicht des Metallsalzes einer organischen Säure mit der polymerisierbaren Gruppe und Polymerisieren der Schicht des Metallsalzes der organischen Säure mittels ultravioletter Strahlen, Elektronstrahlen oder Hitze über der Sliciumenthaltenden Schicht (B) erhalten wird, die den Bereich hoher Stickstoffkonzentration, der über das Basismaterial (A) gebildet ist, enthält.

3. Laminat gemäß einem aus Anspruch 1 oder Anspruch 2, wobei die Energiestrahlenbestrahlung unter Verwendung von Plasmabestrahlung durchgeführt wird.

4. Laminat gemäß Anspruch 3, wobei die Plasmabestrahlung unter einer Atmosphäre, ausgewählt aus Inertgas, Edelgas und reduzierendem Gas, durchgeführt wird.

5. Laminat gemäß Anspruch 3 oder 4, wobei die Plasmabestrahlung bei einer Sauerstoffkonzentration gleich oder geringer als 5000 ppm und einer Wasserdampfkonzentration (Partialdruck von Wasserdampf/Atmosphärendruck bei Raumtemperatur (23°C)) gleich oder geringer als 8400 ppm durchgeführt wird.

6. Laminat gemäß einem der Ansprüche 1 bis 5, wobei die polymerisierbare Gruppe mindestens eine ist, die aus einer Vinylgruppe, einer Epoxidgruppe, einer Mercaptogruppe, eine Ureidogruppe, einer Sulfidgruppe, einer Isocyanatgruppe, einer Aminogruppe, einer Hydroxylgruppe, Halogenatomen, einer Oxazolingruppe, einer Carbodiimidgruppe und Derivaten davon ausgewählt ist.

7. Laminat gemäß einem der Ansprüche 1 bis 6, wobei ein Metall, das das Metallsalz der organischen Säure bildet, mindestens eines ist, das aus Lithium, Natrium, Magnesium, Calcium, Zink und Barium ausgewählt ist.

8. Laminat gemäß einem der Ansprüche 1 bis 7, wobei die Polymerschicht (C) zusätzlich ein Silan-Kupplungsagens enthält.

9. Elektronisches Bauteil, zusammengesetzt aus einem Bauteil, das Elemente enthält, die aus einem organischen Elektrolumineszenz-Element, einem elektronischen Papier-Display-Element und einem Flüssigkristall-Display-Element ausgewählt sind; und dem Laminat gemäß einem der Ansprüche 1 bis 8, das so angeordnet ist, dass die Polymerschicht (C) dem Bauteil zugewandt ist.

10. Verfahren zur Herstellung eines Laminats, umfassend:

Bilden einer Polysilazanschicht über mindestens eine Oberfläche eines Basismaterials (A);
Bestrahlen mit einem Energiestrahl auf die Polysilazanschicht bei einer Sauerstoffkonzentration von gleich oder geringer als 5% und/oder einer relativen
Luftfeuchte bei Raumtemperatur (23°C) von gleich oder
geringer als 30%, um mindestens einen Teil der Schicht zu denaturieren und eine Silicium-enthaltende Schicht (B) zu bilden, die einen Bereich hoher
Stickstoffkonzentration enthält, der aus Siliciumatomen und Stickstoffatomen, Siliciumatomen und
Stickstoffatomen und Sauerstoffatomen oder
Siliciumatomen und Stickstoffatomen und Sauerstoffatomen und Kohlenstoffatomen besteht; und
einen Schritt zur Bildung einer Polymerschicht (C),
erhalten aus einem Metallsalz einer organischen Säure mit einer polymerisierbaren Gruppe, über der Siliciumenthaltenden Schicht (B),
wobei das Zusammensetzungsverhältnis der Stickstoffatome, das mittels Röntgen-Photoelektronenspektroskopie gemessen wird und durch die folgende Formel (1) gegeben ist, im Bereich von 0,01 bis 1 im Bereich hoher Stickstoffkonzentration liegt,

```
Formel (1): aas Zusammensetzungsverhältnis der
Stickstoffatome /(das Zusammensetzungsverhältnis
der Sauerstoffatome + das
Zusammensetzungsverhältnis der Stickstoffatome),
```

und
das Metallsalz einer organischen Säure ein Metallsalz mindestens einer Säure ist, die aus Carboxylsäuren, Sulfonsäuren und Mercaptosäuren ausgewählt ist.

11. Verfahren zur Herstellung eines Laminats gemäß Anspruch 10, wobei die Energiestrahlenbestrahlung unter Verwendung von Plasmabestrahlung durchgeführt wird.

12. Verfahren zur Herstellung eines Laminats gemäß Anspruch 11, wobei die Plasmabestrahlung unter einer Atmosphäre, ausgewählt aus Inertgas, Edelgas und reduzierendem Gas, durchgeführt wird.

**Revendications**

1. Stratifié comprenant :

un matériau de base (A),
une couche contenant du silicium (B) et
une couche de polymère (C) obtenue à partir d'un sel métallique d'acide organique contenant un groupe polymérisable,

dans lequel la couche contenant du silicium (B) et la couche de polymère (C) sont stratifiées de manière séquentielle sur au moins une surface du matériau de base (A),

la couche contenant du silicium (B) comporte une région à concentration élevée en azote composée d'atomes de silicium et d'atomes d'azote, d'atomes de silicium et d'atomes d'azote et d'atomes d'oxygène, ou d'atomes de silicium et d'atomes d'azote et d'atomes d'oxygène et d'atomes de carbone, et

la région à concentration élevée en azote est formée en irradiant un rayon d'énergie sur un film de polysilazane formé sur le matériau de base (A) sous une concentration en oxygène inférieure ou égale à 5 % et/ou une humidité relative à température ambiante (23°C) inférieure ou égale à 30 % afin de dénaturer au moins une partie du film,

dans lequel un rapport de composition des atomes d'azote, qui est mesuré par spectroscopie photoélectronique à rayons X et représenté par la formule (1) suivante, est situé dans une plage allant de 0,01 à 1 dans la région à concentration élevée en azote

Formule (1) : le rapport de composition des atomes d'azote/(le rapport de composition des atomes d'oxygène + le rapport de composition des atomes d'azote),

et

le sel métallique d'acide organique est un sel métallique d'au moins un choisi parmi des acides carboxyliques, des acides sulfoniques et des mercapto-acides.

2.  Stratifié selon la revendication 1,
    dans lequel la couche de polymère (C) est obtenue par la formation d'un film du sel métallique d'acide organique contenant le groupe polymérisable et la polymérisation du film de sel métallique d'acide organique au moyen de rayons ultraviolets, de faisceaux d'électrons ou de chaleur sur la couche contenant du silicium (B) comportant la région à concentration élevée en azote qui est formée sur le matériau de base (A).

3.  Stratifié selon la revendication 1 ou la revendication 2,
    dans lequel l'irradiation du rayon d'énergie est réalisée en utilisant un rayonnement de plasma.

4.  Stratifié selon la revendication 3,
    dans lequel le rayonnement de plasma est réalisé sous une atmosphère choisie parmi un gaz inerte, un gaz rare et un gaz réducteur.

5.  Stratifié selon la revendication 3 ou 4,
    dans lequel le rayonnement de plasma est réalisé à une concentration en oxygène inférieure ou égale à 5000 ppm et à une concentration en vapeur d'eau (pression partielle de vapeur d'eau/pression atmosphérique à température ambiante (23 °C)) inférieure ou égale à 8400 ppm.

6.  Stratifié selon l'une quelconque des revendications 1 à 5,
    dans lequel le groupe polymérisable est au moins un choisi parmi un groupe vinyle, un groupe époxy, un groupe mercapto, un groupe uréido, un groupe sulfure, un groupe isocyanate, un groupe amino, un groupe hydroxyle, des atomes d'halogène, un groupe oxazoline, un groupe carbodiimide et des dérivés de ceux-ci.

7.  Stratifié selon l'une quelconque des revendications 1 à 6,
    dans lequel un métal qui forme le sel métallique d'acide organique est au moins un choisi parmi le lithium, le sodium, le magnésium, le calcium, le zinc et le baryum.

8.  Stratifié selon l'une quelconque des revendications 1 à 7,
    dans lequel la couche de polymère (C) contient en outre un agent de couplage à base de silane.

9.  Elément électronique composé d'un élément comportant des éléments choisis parmi un élément électroluminescent organique, un élément d'affichage de papier électronique et un élément d'affichage à cristaux liquides ; et le stratifié selon l'une quelconque des revendications 1 à 8 pourvu de la couche de polymère (C) en face de l'élément.

10. Procédé de fabrication d'un stratifié comprenant :

la formation d'un film de polysilazane sur au moins une surface d'un matériau de base (A) ;

l'irradiation d'un rayon d'énergie sur le film de polysilazane sous une concentration en oxygène inférieure ou égale à 5 % et/ou une humidité relative à température ambiante (23 °C) inférieure ou égale à 30 % afin de dénaturer au moins une partie du film et de former une couche contenant du silicium (B) comportant une région à concentration élevée en azote composée d'atomes de silicium et d'atomes d'azote, d'atomes de silicium et d'atomes d'azote et d'atomes d'oxygène, ou d'atomes de silicium, d'atomes d'azote, d'atomes d'oxygène et d'atomes de carbone ; et

une étape de formation d'une couche de polymère (C) obtenue à partir d'un sel métallique d'acide organique contenant un groupe polymérisable sur la couche contenant du silicium (B),

dans lequel un rapport de composition des atomes d'azote, qui est mesuré par spectroscopie photoélectronique à rayons X et représenté par la formule (1) suivante, est situé dans une plage allant de 0,01 à 1 dans la région à concentration élevée en azote

Formule (1) : le rapport de composition des atomes d'azote/(le rapport de composition des atomes d'oxygène + le rapport de composition des atomes d'azote),

et

le sel métallique d'acide organique est un sel métallique d'au moins un choisi parmi des acides carboxyliques, des acides sulfoniques et des mercapto-acides.

11. Procédé de fabrication d'un stratifié selon la revendication 10,
dans lequel l'irradiation du rayon d'énergie est réalisée en utilisant un rayonnement de plasma.

12. Procédé de fabrication d'un stratifié selon la revendication 11,
dans lequel le rayonnement de plasma est réalisé sous un gaz d'atmosphère choisi parmi un gaz inerte, un gaz rare et un gaz réducteur.

Fig.1

10

Fig.2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 2455220 A1
- EP 2599621 A1
- JP 2007237588 A
- JP 2009095989 A

- JP 2003211576 A
- JP 6316025 A
- JP 2010042574 A
- WO 20117543 A